# EUROPEAN PATENT APPLICATION

(11) **EP 4 664 716 A1**
(43) Date of publication of application: **17.12.2025**
(21) Application number: 24779525.5
(22) Date of filing: 14.03.2024
(51) Int. Cl.: H02J 7/00

(54) **INFORMATION PROCESSING METHOD, INFORMATION PROCESSING DEVICE, AND INFORMATION PROCESSING PROGRAM**

(30) Priority: 24.03.2023 JP 2023048647
(71) Applicant: Panasonic Intellectual Property Management Co., Ltd., Kadoma-shi, Osaka 571-0057 (JP)
(72) Inventor: HAYASHI, Yuki, Kadoma-shi, Osaka 571-0057 (JP); NAGASHIMA, Tatsumi, Kadoma-shi, Osaka 571-0057 (JP); HIRATA, Yuki, Kadoma-shi, Osaka 571-0057 (JP)
(74) Representative: Grünecker Patent- und Rechtsanwälte PartG mbB
(86) International application number: PCT/JP2024/010034
(87) International publication number: WO 2024/203396

(57) **Abstract**

An information terminal acquires a plurality of abnormal state items indicating a state item for which an abnormal value is detected from among a plurality of state items indicating a plurality of states of a plurality of batteries, upon receiving selection of one abnormal state item of one battery among the plurality of abnormal state items having been acquired, acquires a related state item indicating a state item related to the one abnormal state item having been selected from among the plurality of state items of the one battery, and displays an operation history of the related state item having been acquired.

## Description

### Technical Field

The present disclosure relates to a technique of displaying an operation history of a battery in which an abnormal value is detected.

### Background Art

For example, Patent Literature 1 discloses that a battery that is abnormally deteriorated is diagnosed from an operating history and a model of the battery, and a coefficient of an item that is out of a constraint condition is displayed in a highlighted manner.

Since there is a plurality of types of errors in the battery, a manager needs to confirm not only an item determined to be abnormal but also other item related to the item.

However, in the conventional technique described above, only an item determined to be abnormal is displayed in a highlighted manner, and further improvement is required.

### Citation List

### Patent Literature

Patent Literature 1: JP 2018-169161 A

### Summary of Invention

The present disclosure has been made to solve the above problem, and an object of the present disclosure is to provide a technique capable of supporting a user's determination of what type of error has occurred in a battery.

An information processing method of the present disclosure is an information processing method in a computer, the method including acquiring a plurality of abnormal state items indicating a state item for which an abnormal value is detected from among a plurality of state items indicating a plurality of states of a plurality of batteries, upon receiving selection of one abnormal state item of one battery among the plurality of abnormal state items having been acquired, acquiring a related state item indicating a state item related to the one abnormal state item having been selected from among the plurality of state items of the one battery, and displaying an operation history of the related state item having been acquired.

The present disclosure can support the user's determination of what type of error has occurred in the battery.

### Brief Description of Drawings

FIG. 1 is a diagram illustrating an overall configuration of a battery management system in an embodiment of the present disclosure.
FIG. 2 is a sequence diagram for describing an operation of the battery management system in the embodiment of the present disclosure.
FIG. 3 is a diagram illustrating an example of an abnormal state item display screen displaying a list of a plurality of abnormal state items in the present embodiment.
FIG. 4 is a diagram illustrating an example of an abnormal state item display screen displaying a list of a plurality of abnormal state items in Modification 1 of the present embodiment.
FIG. 5 is a diagram illustrating an example of an abnormal state item display screen displaying a list of a plurality of abnormal state items in Modification 2 of the present embodiment.
FIG. 6 is a diagram illustrating an example of a related state item display screen displaying an operation history of a related state item in the present embodiment.
FIG. 7 is a flowchart for describing related state item extraction processing of a server in the embodiment of the present disclosure.
FIG. 8 is a diagram illustrating an example of a related state item table stored in advance in a memory in the present embodiment.
FIG. 9 is a flowchart for describing abnormality degree assignment processing of a server in Modification 3 of the embodiment of the present disclosure.
FIG. 10 is a schematic diagram for describing a first assignment method of an abnormality degree in Modification 3 of the present embodiment.
FIG. 11 is a schematic diagram for describing a second assignment method of the abnormality degree in Modification 3 of the present embodiment.
FIG. 12 is a diagram for describing the abnormality degree assigned to a plurality of state items of one battery in Modification 3 of the present embodiment.
FIG. 13 is a flowchart for describing related state item extraction processing of the server in Modification 3 of the embodiment of the present disclosure.
FIG. 14 is a diagram illustrating an example of a related state item display screen displaying an operation history of a related state item in Modification 3 of the embodiment of the present disclosure.
FIG. 15 is a flowchart for describing table update processing of the server in the embodiment of the present disclosure.
FIG. 16 is a schematic diagram for describing update of the related state item table in the present embodiment.
FIG. 17 is a flowchart for describing related state item extraction processing of a server in Modification 4 of the embodiment of the present disclosure.
FIG. 18 is a diagram illustrating an example of a prediction error table in Modification 4 of the embodiment of the present disclosure.
FIG. 19 is a flowchart for describing related state item extraction processing of a server in Modification 5 of the embodiment of the present disclosure.
FIG. 20 is a diagram illustrating an example of a related state item display screen displaying an operation history of a related state item in Modification 5 of the present embodiment.
FIG. 21 is a diagram illustrating another example of the related state item display screen displaying the operation history of the related state item in Modification 5 of the present embodiment.
FIG. 22 is a diagram illustrating an example of a display screen displaying a value of a related state item of one battery and a value of a related state item of another battery in Modification 5 of the present embodiment.
FIG. 23 is a flowchart for describing error information assignment processing of the server in the embodiment of the present disclosure.
FIG. 24 is a flowchart for describing related state item extraction processing of a server in Modification 6 of the embodiment of the present disclosure.
FIG. 25 is a diagram illustrating an example of a related state item display screen displaying an operation history of a related state item in Modification 6 of the present embodiment.

### Description of Embodiments

### (Knowledge Underlying Present Disclosure)

As described above, in the conventional technique, only the item determined to be abnormal is displayed in a highlighted manner. It has been therefore difficult to support a manager's determination of what type of error has occurred in a battery, and to support the manager to better understand the cause of the error that has occurred in the battery.

In order to solve the above problem, the following technique is disclosed.
(1) An information processing method according to an aspect of the present disclosure is an information processing method in a computer, the method including acquiring a plurality of abnormal state items indicating a state item for which an abnormal value is detected from among a plurality of state items indicating a plurality of states of a plurality of batteries, upon receiving selection of one abnormal state item of one battery among the plurality of abnormal state items having been acquired, acquiring a related state item indicating a state item related to the one abnormal state item having been selected from among the plurality of state items of the one battery, and displaying an operation history of the related state item having been acquired.

In this configuration, among the plurality of state items of one battery, not only the operation history of one abnormal state item in which an abnormal value is detected, but also the operation history of the related state item related to one abnormal state item is displayed.

Therefore, the user who is the manager of the plurality of batteries can determine what type of error has occurred in the battery by viewing not only the operation history of one abnormal state item but also the operation history of the related state item related to one abnormal state item. It is therefore possible to support the user's determination of what type of error has occurred in the battery.

In the conventional technique, only the operation history of the abnormal state item is displayed in a highlighted manner. In the conventional technique, in order to display the operation history of the related state item for determination of what type of error has occurred in the battery, it is necessary to display the operation history of all the state items of one battery, receive the user's selection of the state item related to the abnormal state item from the operation history, determine the state item to be displayed on the basis of the selection, and then display the operation history of the state item again. On the other hand, in the above configuration, not only the operation history of the abnormal state item but also the operation history of the corresponding related state item is displayed. As a result, in the above configuration, the processing sequence can be omitted. Therefore, an effect of reducing computer resources is obtained by omitting the processing sequence.

(2) The information processing method according to (1) further may include acquiring the operation history of the plurality of state items of the one battery, in which in the displaying of the operation history, the operation history of the plurality of state items having been acquired is displayed, and the operation history of the related state item having been acquired is displayed in a mode different from an operation history of another state item other than the related state item.

In this configuration, since the operation history of the plurality of state items of one battery is displayed and the operation history of the related state item is displayed in a mode different from the operation history of another state item other than the related state item, the user can easily distinguish the related state item necessary for determining an error that has occurred in a battery from among the plurality of displayed state items of the one battery.

(3) In the information processing method according to (1) or (2), in the acquiring of the related state item, the related state item associated with the one abnormal state item having been selected may be extracted from a table in which each of the plurality of abnormal state items and the related state item are associated in advance, and the related state item having been extracted may be acquired.

In this configuration, since the related state item associated with the one abnormal state item is extracted from the table, the related state item related to the one abnormal state item can be easily specified.

(4) In the information processing method according to (3), further may include updating the table to change the current related state item to a new related state item, when a change of the related state item associated with the abnormal state item is received.

In this configuration, it is possible to delete an unnecessary related state item from the table and add a necessary related state item to the table when determining an error that has occurred in the battery.

(5) In the information processing method according to any one of (1) to (4), in the acquiring of the related state item, when another abnormal state item different from the one abnormal state item exists in the plurality of state items of the one battery, the other abnormal state item may be extracted as the related state item, and the related state item having been extracted may be acquired.

In this configuration, when another abnormal state item different from the one abnormal state item exists in the plurality of state items of one battery, the other abnormal state item is extracted as the related state item, and the extracted related state item is acquired.

Therefore, since the operation history of the other abnormal state item different from the one abnormal state item is displayed, the user can confirm the other abnormal state item in which the abnormal value is detected and more accurately determine what type of error has occurred in the battery.

(6) In the information processing method according to (5), the abnormal state item may be associated with an abnormality degree indicating a degree to which the operation history exceeds a threshold, and in the acquiring of the related state items, when a plurality of other abnormal state items different from the one abnormal state item exists in the plurality of state items of the one battery, the plurality of other abnormal state items may be extracted as a plurality of related state items on a basis of the abnormality degree associated with each of the plurality of other abnormal state items, and the plurality of related state items having been extracted may be acquired.

In this configuration, the abnormal state item is associated with an abnormality degree indicating a degree to which the operation history exceeds the threshold. When a plurality of other abnormal state items different from the one abnormal state item exists in the plurality of state items of the one battery, the plurality of other abnormal state items is extracted as the plurality of related state items on the basis of the abnormality degree associated with each of the plurality of other abnormal state items, and the plurality of extracted related state items is acquired.

Therefore, for example, by extracting another abnormal state item having a high abnormality degree as a related state item and not extracting another abnormal state item having a low abnormality degree as a related state item, it is possible to narrow down related state items necessary for determining an error that has occurred in the battery.

(7) In the information processing method according to (6), in the displaying of the operation history, the operation history of each of the plurality of related state items may be displayed in a different mode in accordance with the abnormality degree associated with each of the plurality of other abnormal state items.

In this configuration, the operation history of each of the plurality of related state items is displayed in a different mode in accordance with the abnormality degree associated with each of the plurality of other abnormal state items. Therefore, for example, by displaying the operation history of another abnormal state item having a high abnormality degree in a highlighted manner more than the operation history of another abnormal state item having a low abnormality degree, the user can easily recognize the other abnormal state item having a high abnormality degree, and the user's determination of what type of error has occurred in the battery can be supported.

(8) In the information processing method according to any one of (1) to 4, in the acquiring of the related state item, when another abnormal state item different from the one abnormal state item exists in the plurality of state items of the one battery, the other abnormal state item may be extracted as a related state item, an error that has occurred in the one battery may be predicted on a basis of a combination of the one abnormal state item and the other abnormal state item, and the related state item having been extracted and an error item indicating the error having been predicted may be acquired, and in the displaying of the operation history, the operation history of the related state item and the error item may be displayed.

In this configuration, an error that has occurred in one battery is predicted on the basis of a combination of one abnormal state item and another abnormal state item, and an error item indicating the predicted error is displayed together with the operation history of the related state item. It is therefore possible to support the user's determination of what type of error has occurred in the battery.

(9) In the information processing method according to any one of (1) to (4), in the acquiring of the related state item, another battery similar to the one battery may be specified among the plurality of batteries, and an operation history of a same state item as the related state item may be acquired among the plurality of state items of the other battery having been specified, and in the displaying of the operation history, the operation history of the related state item may be displayed, and the operation history of the same state item of the other battery as the related state item of the one battery may be displayed.

In this configuration, another battery similar to one battery is specified, the operation history of the related state item of the one battery is displayed, and the operation history of the state item of the other battery same as the related state item of the one battery is displayed. Therefore, since the operation history of the related state item of one battery can be presented to the user in comparison with the operation history of the state item of the other battery same as the related state item of the one battery, it is possible to support the user's determination of what type of error has occurred in the battery.

(10) In the information processing method according to (9), in the specifying of the other battery, a battery having a same abnormal state item as the one battery, a battery of a same type as the one battery, a battery mounted on a device of a same type as a device on which the one battery is mounted, or a battery used in an environment similar to the one battery may be specified as the other battery.

In this configuration, a battery having the same abnormal state item as the one battery, a battery of the same type as the one battery, a battery mounted on a device of the same type as a device on which the one battery is mounted, or a battery used in an environment similar to the one battery is specified as the other battery. Therefore, another battery similar to the one battery can easily specified.

(11) In the information processing method according to (9), in the acquiring of the related state item, when another abnormal state item different from the one abnormal state item exists in the plurality of state items of the one battery, the other abnormal state item may be extracted as a related state item, an error that has occurred in the one battery may be predicted on a basis of a combination of the one abnormal state item and the other abnormal state item, and a battery in which a same error as the error having been predicted has occurred in past among the plurality of batteries may be specified as the other battery.

In this configuration, since a battery in which the same error as the error having occurred in one battery has occurred in the past is specified as another battery similar to one battery, another battery similar to one battery can be easily specified.

(12) In the information processing method according to any one of (1) to (4), in the acquiring of the related state item, the related state item associated with the one abnormal state item having been selected may be extracted from a table in which each of the plurality of abnormal state items and the related state item are associated in advance, a feature amount may be calculated on a basis of the operation history of the related state item, clustering may be executed by using the operation history of the plurality of state items in past of each of the plurality of batteries as a data set, a clustering result may be mapped in a two-dimensional space and a mapping image in which the feature amount is plotted in the two-dimensional space may be created, and the related state item having been extracted and the mapping image having been created may be acquired, and in the displaying of the operation history, the operation history of the related state item and the mapping image may be displayed.

In this configuration, the feature amount is calculated on the basis of the operation history of the related state item, and clustering is executed by using the operation history of the plurality of past state items of each of the plurality of batteries as the data set. Then, a mapping image in which the clustering result is mapped on the two-dimensional space and the feature amount is plotted on the two-dimensional space is created. Thereafter, the operation history of the related state item and the mapping image are displayed.

Therefore, the user can predict the error that has occurred in one battery by confirming, in the mapping image, the position of the plurality of clusters in which the operation history of the plurality of past state items of the plurality of batteries is classified and the position of the feature amount calculated on the basis of the operation history of the related state items.

The present disclosure can be implemented not only as an information processing method for executing the characteristic processing as described above, but also as an information processing device or the like having a characteristic configuration corresponding to characteristic processing executed by the information processing method. The present disclosure can also be implemented as a computer program that causes a computer to execute characteristic processing included in the information processing method described above. Therefore, an effect similar to the effect in the above information processing method can also be achieved by another aspect described below.

(13) An information processing device according to another aspect of the present disclosure includes a first acquisition part that acquires a plurality of abnormal state items indicating a state item for which an abnormal value is detected from among a plurality of state items indicating a plurality of states of a plurality of batteries, a second acquisition part that acquires a related state item, upon receiving selection of one abnormal state item of one battery among the plurality of abnormal state items having been acquired, the related state item indicating a state item related to the one abnormal state item having been selected from among the plurality of state items of the one battery, and a display part that displays an operation history of the related state item having been acquired.

(14) An information processing program according to another aspect of the present disclosure causes a computer to function to acquire a plurality of abnormal state items indicating a state item for which an abnormal value is detected from among a plurality of state items indicating a plurality of states of a plurality of batteries, upon receiving selection of one abnormal state item of one battery among the plurality of abnormal state items having been acquired, acquire a related state item indicating a state item related to the one abnormal state item having been selected from among the plurality of state items of the one battery, and display an operation history of the related state item having been acquired.

(15) A computer-readable recording medium according to another aspect of the present disclosure records an information processing program, and the information processing program causes a computer to function to acquire a plurality of abnormal state items indicating a state item for which an abnormal value is detected from among a plurality of state items indicating a plurality of states of a plurality of batteries, upon receiving selection of one abnormal state item of one battery among the plurality of abnormal state items having been acquired, acquire a related state item indicating a state item related to the one abnormal state item having been selected from among the plurality of state items of the one battery, and display an operation history of the related state item having been acquired.

Hereinafter, embodiments of the present disclosure will be described with reference to the accompanying drawings. Each of embodiments described below illustrates a specific example of the present disclosure. Numerical values, shapes, constituent elements, steps, order of steps, and the like of the embodiment below are merely examples, and do not intend to limit the present disclosure. A constituent element not described in an independent claim representing a highest concept among constituent elements in the embodiments below is described as an optional constituent element. In all the embodiments, respective contents can be combined.

### (Embodiments)

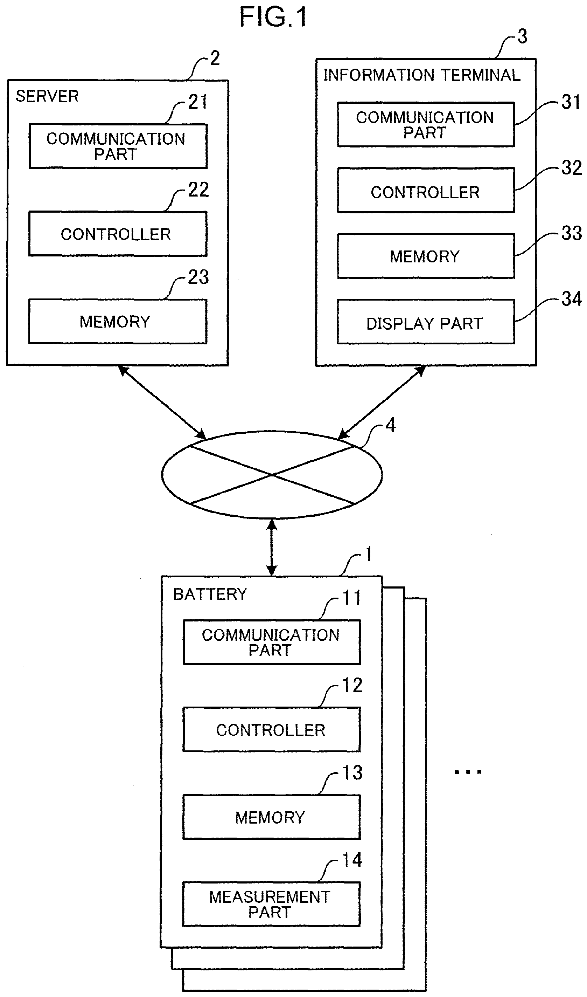

FIG. 1 is a diagram illustrating an overall configuration of a battery management system in an embodiment of the present disclosure.

The battery management system illustrated in FIG. 1 includes a plurality of batteries 1, a server 2, and an information terminal 3.

Each of the batteries 1 includes a plurality of secondary batteries, and stores electric power by charging, and supplies electric power by discharging. The secondary battery is, for example, a lead acid battery or a lithium ion battery. The battery 1 is a battery pack including a plurality of battery cells. The battery 1 is mounted as a power source on various devices. The battery 1 is mounted on an electric mobile body such as an electric vehicle, for example.

The battery 1 is not limited to an in-vehicle battery mounted on an electric mobile body, and may be a stationary storage battery, a fuel cell, or a solar cell used in an energy management business or the like.

The battery 1 includes a communication part 11, a controller 12, a memory 13, and a measurement part 14.

The measurement part 14 measures a plurality of state items of the battery 1. The measurement part 14 measures the plurality of state items such as a field effect transistor (FET) temperature, a cell temperature, a pack temperature, an ambient temperature, a cell current, a cell voltage, a pack current, a pack voltage, a pack resistance, the number of times of charging, a cumulative charge amount, a cumulative discharge amount, a pack full charge amount, and a state of charge (SOC). The measurement part 14 stores measured values of the plurality of state items in the memory 13. The plurality of state items are not limited to the above items, and may be simply a battery temperature, a battery current, or a battery voltage, or may be a use time of the battery 1, a travel distance of the electric mobile body on which the battery 1 is mounted, or the like. In a case where the battery 1 is a fuel cell or a solar cell, the pack current, the pack voltage, and the number of times of charging of the state items may be an output current, an output voltage, and the number of times of output.

The memory 13 is, for example, a storage device, such as a random access memory (RAM), a solid state drive (SSD), or a flash memory, capable of storing various types of information. The memory 13 stores an operation history of the plurality of state items measured by the measurement part 14.

The controller 12 is, for example, a central processing unit (CPU), reads the operation history of the plurality of state items from the memory 13, and creates battery log information including a battery ID for identifying the battery 1 and the read operation history of the plurality of state items. The controller 12 outputs the created battery log information to the communication part 11.

The communication part 11 transmits the battery log information of the battery 1 to the server 2. The battery log information includes a battery ID of the battery 1 and the operation history of the plurality of state items of the battery 1. The communication part 11 periodically transmits the battery log information to the server 2. For example, the communication part 11 may transmit the battery log information including the operation history of the plurality of state items measured for one minute to the server 2 every one minute.

Although the battery 1 includes the communication part 11, the controller 12, the memory 13, and the measurement part 14 in the present embodiment, the present disclosure is not limited to this configuration, and a device on which the battery 1 is mounted may include the communication part 11, the controller 12, the memory 13, and the measurement part 14.

The server 2 is communicably connected to the plurality of batteries 1 and the information terminal 3 via a network 4. The network 4 is the Internet, for example.

The server 2 includes a communication part 21, a controller 22, and a memory 23.

The communication part 21 receives the battery log information transmitted by the battery 1. The communication part 21 outputs the received battery log information to the controller 22.

The memory 23 is a storage device, such as a random access memory (RAM), a solid state drive (SSD), a hard disk drive (HDD), or a flash memory, capable of storing various types of information. The memory 23 stores the battery log information. The memory 23 stores the operation history of the plurality of state items in association with the battery ID. The memory 23 stores the operation history of the plurality of state items of each of the plurality of batteries 1.

The memory 23 stores a related state item table in which each of a plurality of abnormal state items indicating the state item in which an abnormal value is detected and a related state item indicating the state item related to the abnormal state item are associated in advance. The abnormal value indicates a value exceeding a threshold. The threshold varies depending on the state item.

The communication part 21 transmits, to the information terminal 3, the plurality of abnormal state items indicating the state item in which the abnormal value is detected from among the plurality of state items indicating a plurality of states of the plurality of batteries 1.

The communication part 21 receives data request transmitted by the information terminal 3. The data request includes one abnormal state item of one battery selected by a user.

The controller 22 is, for example, a CPU. The controller 22 stores the battery log information received by the communication part 21 in the memory 23. The controller 22 extracts a related state item indicating a state item related to one abnormal state item included in the data request from among a plurality of state items of one battery included in the data request received by the communication part 21. The controller 22 extracts the related state item associated with the selected one abnormal state item from the related state item table in which each of the plurality of abnormal state items and the related state item are associated in advance.

The communication part 21 transmits the related state item extracted by the controller 22 to the information terminal 3. The communication part 21 transmits the operation history of all of the plurality of state items of one battery included in the data request received by the communication part 21 to the information terminal 3.

When a change of the related state item associated with the abnormal state item is received, the controller 22 updates the related state item table stored in the memory 23 to change the current related state item to a new related state item.

The information terminal 3 is, for example, a smartphone, a tablet computer, or a personal computer, and is used by a manager who manages the plurality of batteries 1.

The information terminal 3 includes a communication part 31, a controller 32, a memory 33, and a display part 34.

The communication part 31 receives a plurality of abnormal state items transmitted by the server 2. The communication part 31 acquires the plurality of abnormal state items indicating the state item in which the abnormal value is detected from among the plurality of state items indicating a plurality of states of the plurality of batteries 1.

The controller 32 is, for example, a CPU. The controller 32 controls the display part 34 to display a list of the plurality of abnormal state items received by the communication part 31.

The display part 34 is, for example, a touch panel, and displays a list of the plurality of abnormal state items received by the communication part 31. At this time, the display part 34 receives selection by the user of one abnormal state item of one battery among the plurality of abnormal state items received by the communication part 31.

The communication part 31 transmits a data request for requesting a related state item related to one abnormal state item of selected one battery to the server 2. The communication part 31 receives the related state item transmitted by the server 2. Upon receiving the selection of one abnormal state item of one battery among the plurality of acquired abnormal state items, the communication part 31 acquires a related state item indicating a state item related to the selected one abnormal state item among the plurality of state items of one battery. The communication part 31 receives the operation history of all of the plurality of state items of one battery transmitted by the server 2. That is, the communication part 31 acquires an operation history of a plurality of state items of one battery.

The memory 33 is, for example, a storage device that can store various types of information, such as a RAM, an SSD, an HDD, or a flash memory. The memory 33 stores the operation history of the plurality of state items of one battery received by the communication part 31.

The controller 32 controls the display part 34 to display the related state item received by the communication part 31. The display part 34 displays the operation history of the acquired related state item. Here, the display part 34 displays the acquired operation history of the plurality of state items of one battery, and displays the acquired operation history of the related state item in a different mode from the operation history of other state items other than the related state item.

Although the battery management system in the present embodiment includes the plurality of batteries 1, the server 2, and the information terminal 3, the present disclosure is not limited to this configuration, and the battery management system may include the plurality of batteries 1 and the information terminal 3 without including the server 2. In this case, the information terminal 3 has a function of the server 2.

Next, an operation of the battery management system in the embodiment of the present disclosure will be described.

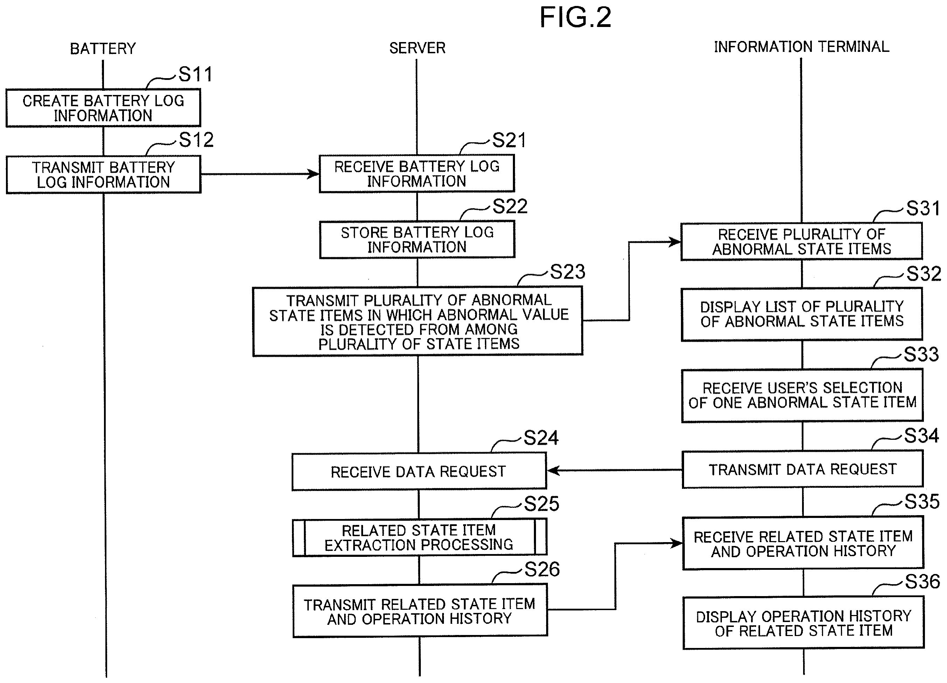

FIG. 2 is a sequence diagram for describing the operation of the battery management system in the embodiment of the present disclosure.

First, in step S11, the controller 12 of the battery 1 creates battery log information including the battery ID and the operation history of the plurality of state items.

Next, in step S12, the communication part 11 of the battery 1 transmits the battery log information of the battery 1 created by the controller 12 to the server 2. The battery management system includes a plurality of batteries 1. Therefore, each of the plurality of batteries 1 transmits the battery log information to the server 2.

Next, in step S21, the communication part 21 of the server 2 receives the battery log information transmitted by the battery 1. The communication part 21 receives a plurality of pieces of battery log information transmitted by the plurality of batteries 1.

Next, in step S22, the controller 22 of the server 2 stores the battery log information received by the communication part 21 in the memory 23. The controller 22 stores the battery log information of the plurality of batteries 1 in the memory 23.

Next, in step S23, the communication part 21 transmits a plurality of abnormal state items in which an abnormal value is detected from among the plurality of state items to the information terminal 3. At this time, the controller 22 extracts a plurality of abnormal state items in which an abnormal value is detected from among the plurality of state items included in the battery log information stored in the memory 23, and outputs the extracted plurality of abnormal state items to the communication part 21. Each of the plurality of abnormal state items is associated with an abnormal state item of any of the batteries.

A temporal range in which the plurality of abnormal state items is extracted from the battery log information can be changed, and a change by the user may be accepted. For example, in a case where an error occurs in December, there is a high possibility that the data of March is unnecessary. Therefore, the controller 22 may extract a plurality of abnormal state items from the battery log information of the latest October to December.

Next, in step S31, the communication part 31 of the information terminal 3 receives a plurality of abnormal state items transmitted by the server 2.

Next, in step S32, the display part 34 displays a list of the plurality of abnormal state items received by the communication part 31.

Next, in step S33, the display part 34 receives selection by the user of one abnormal state item of one battery among the plurality of abnormal state items received by the communication part 31.

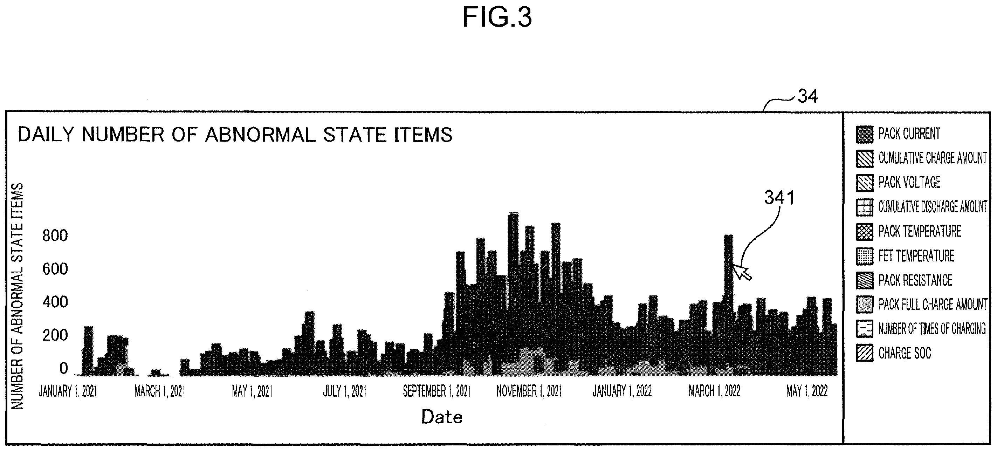

FIG. 3 is a diagram illustrating an example of an abnormal state item display screen displaying a list of the plurality of abnormal state items in the present embodiment.

The display part 34 displays the abnormal state item display screen illustrated in FIG. 3. The abnormal state item display screen includes a bar graph indicating the number of abnormal state items occurring in a predetermined period. The vertical axis represents the number of abnormal state items, and the horizontal axis represents day, month, and year. The bar graphs are stacked by being color-coded in accordance with the abnormal state item.

For example, the abnormal state item includes a pack current, a cumulative charge amount, a pack voltage, a cumulative discharge amount, a pack temperature, an FET temperature, a pack resistance, a pack full charge amount, the number of times of charging, and a charge SOC. Explanatory note for describing the colors corresponding to the abnormal state items are displayed next to the bar graph. For example, the color corresponding to the pack current is blue, the color corresponding to the cumulative charge amount is red, the color corresponding to the pack voltage is green, and the color corresponding to the cumulative discharge amount is yellow.

The stacked bar graphs are selectable. For example, the user moves a pointer 341 on a screen by operating a mouse (not illustrated) and clicks on a desired bar graph. Alternatively, for example, in a case where the display part 34 is a touch panel, the user touches a desired bar graph. One abnormal state item of one battery is selected by selecting one point of a desired bar graph.

In the present embodiment, the display part 34 displays a list of a plurality of abnormal state items by stacked bar graphs, but the present disclosure is not limited to this display. In Modification 1 of the present embodiment, the display part 34 may display a list of the plurality of abnormal state items by a donut chart.

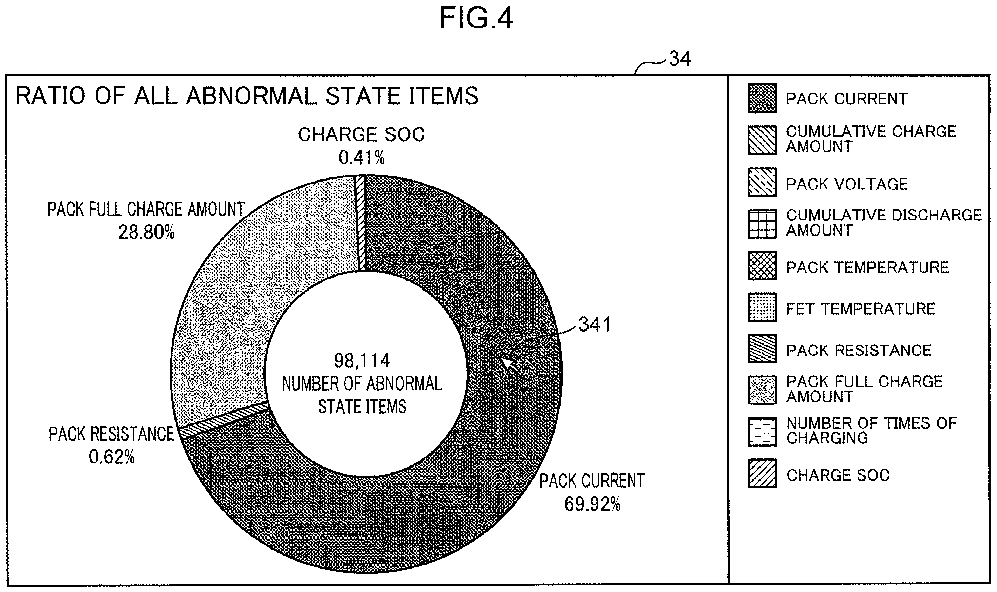

FIG. 4 is a diagram illustrating an example of the abnormal state item display screen displaying a list of the plurality of abnormal state items in Modification 1 of the present embodiment.

The display part 34 may display the abnormal state item display screen illustrated in FIG. 4. The abnormal state item display screen includes a donut chart indicating a ratio of each abnormal state item to a total number of abnormal state items in which an abnormality has occurred during a predetermined period. The donut chart is color-coded in accordance with the abnormal state items, and represents a ratio of the abnormal state items generated within a predetermined period.

For example, the abnormal state item includes a pack current, a cumulative charge amount, a pack voltage, a cumulative discharge amount, a pack temperature, an FET temperature, a pack resistance, a pack full charge amount, the number of times of charging, and a charge SOC. Explanatory note for describing the colors corresponding to the abnormal state items are displayed next to the donut chart. For example, the color corresponding to the pack current is blue, the color corresponding to the cumulative charge amount is red, the color corresponding to the pack voltage is green, and the color corresponding to the cumulative discharge amount is yellow.

The donut chart is selectable. For example, the user moves the pointer 341 on the screen by operating the mouse (not illustrated) and clicks on a desired donut chart. Alternatively, for example, in a case where the display part 34 is a touch panel, the user touches a desired donut chart. One abnormal state item of one battery is selected by selecting one point of a desired donut chart.

Note that, in Modification 1 of the present embodiment, a plurality of abnormal state items is displayed as a list by a donut chart, but a plurality of abnormal state items may be displayed as a list by a pie chart.

In Modification 2 of the present embodiment, the display part 34 may display a list of the plurality of abnormal state items by a table.

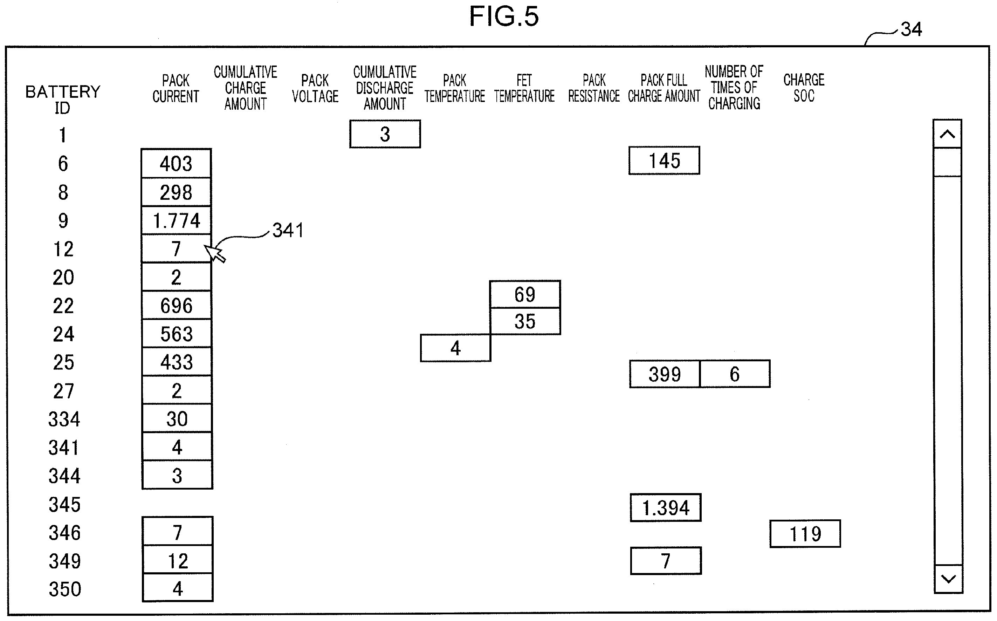

FIG. 5 is a diagram illustrating an example of the abnormal state item display screen displaying a list of the plurality of abnormal state items in Modification 2 of the present embodiment.

The display part 34 may display the abnormal state item display screen illustrated in FIG. 5. The abnormal state item display screen includes a table in which the number of occurrence of abnormal value of each of the plurality of abnormal state items in the predetermined period is associated with the battery ID. A row label item on a vertical axis indicates a battery pack ID, a column label on a horizontal axis indicates an abnormal state item, and a value area indicates the number of occurrence of abnormal value of each abnormal state item within a predetermined period.

For example, the abnormal state item includes a pack current, a cumulative charge amount, a pack voltage, a cumulative discharge amount, a pack temperature, an FET temperature, a pack resistance, a pack full charge amount, the number of times of charging, and a charge SOC. For example, in the battery having the battery ID "1", the number of times of occurrence of abnormal value of the cumulative discharge amount within a predetermined period is 3, and in the battery having the battery ID "6", the number of times of occurrence of abnormal value of the pack current within a predetermined period is 403, and the number of times of occurrence of abnormal value of the pack full charge amount within a predetermined period is 145.

The table is selectable. For example, the user moves the pointer 341 on the screen by operating the mouse (not illustrated) and clicks on a desired field on the table. Alternatively, for example, in a case where the display part 34 is a touch panel, the user touches a desired field on the table. One abnormal state item of one battery is selected by selecting a desired field.

Referring to FIG. 2 again, next, in step S34, the communication part 31 transmits a data request for requesting a related state item related to one abnormal state item of selected one battery to the server 2. The data request includes information (battery ID) indicating one battery selected by the user and information indicating one abnormal state item.

Next, in step S24, the communication part 21 of the server 2 receives the data request transmitted by the information terminal 3.

Subsequently, in step S25, the controller 22 executes related state item extraction processing of extracting a related state item indicating a state item related to one abnormal state item included in the data request from among a plurality of state items of one battery included in the data request received by the communication part 21. Note that the related state item extraction processing will be described later.

Next, in step S26, the communication part 21 transmits the related state item extracted by the controller 22 and the operation history of all of the plurality of state items of one battery included in the data request to the information terminal 3.

Subsequently, in step S35, the communication part 31 of the information terminal 3 receives the related state item transmitted by the server 2 and the operation history of all of the plurality of state items of one battery.

Next, in step S36, the display part 34 displays the operation history of the related state item received by the communication part 31. Here, the display part 34 displays the operation history of the plurality of state items of one battery, and displays the operation history of the related state item in a different mode from the operation history of other state items other than the related state item.

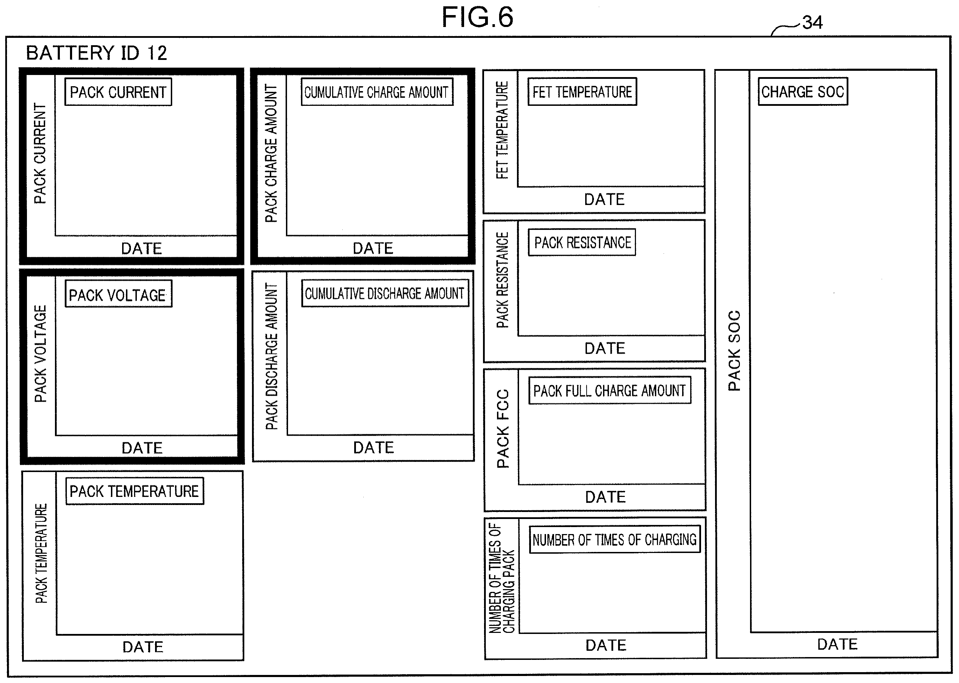

FIG. 6 is a diagram illustrating an example of the related state item display screen displaying the operation history of the related state item in the present embodiment.

The display part 34 displays the operation history of the plurality of state items of one battery, and displays the operation history of the related state item among the plurality of state items in a highlighted manner. In FIG. 6, the pack current, the pack voltage, and the cumulative charge amount are related state items. The pack temperature, the cumulative discharge amount, the FET temperature, the pack resistance, the pack full charge amount, the number of times of charging, and the charge SOC are other state items. The display part 34 displays the operation history of the related state item in a highlighted manner by surrounding a periphery of the operation histories of these three related state items with a frame of a predetermined color. The predetermined color is, for example, red, and the color of the frame surrounding the operation history of the related state item is different from the color of the frame surrounding the operation history of other state items. The display part 34 may display a frame surrounding the operation history of the related state item to be thicker than the frame surrounding the operation history of other state items.

Note that the display part 34 may change the order of displaying the operation history of the related state item. For example, the display part 34 may display the operation history of the related state items in an order prioritizing the operation history of the other state items. The display part 34 may change the position where the operation history of the related state item is displayed. The display part 34 may change the size of display of the operation history of the related state item. For example, the display part 34 may display the operation history of the related state item to be larger than the operation history of other state items.

It is satisfactory that the display part 34 displays only the operation history of the related state item. The display part 34 may set the luminance of the operation history of the related state item to be displayed to be higher than the luminance of the operation history of other state items to be displayed. The display part 34 may display the operation history of one abnormal state item included in the data request received in step S24 among the related state items in a different mode from the operation history of other related state items. This display shows which related state item has been selected by the user among the plurality of displayed related state items.

In this manner, among the plurality of state items of one battery, not only the operation history of one abnormal state item for which an abnormal value is detected, but also the operation history of the related state item related to one abnormal state item is displayed.

Therefore, the user who is the manager of the plurality of batteries 1 can determine what type of error has occurred in the battery 1 by viewing not only the operation history of one abnormal state item but also the operation history of the related state item related to one abnormal state item. It is therefore possible to support the user's determination of what type of error has occurred in the battery 1.

Furthermore, in the present embodiment, not only the operation history of the abnormal state item but also the operation history of the corresponding related state item are displayed together without receiving selection from the user for displaying the operation history of the related state item or updating a display content. Therefore, in the present embodiment, the processing sequence can be omitted as compared with the conventional technique. Therefore, an effect of reducing computer resources is obtained by omitting the processing sequence.

In the present embodiment, in step S26, the communication part 21 transmits the operation history of all of the plurality of state items of one battery included in the data request to the information terminal 3, but the present disclosure is not limited to this configuration. Between step S22 and step S23, or in step S23, the communication part 21 may transmit the operation history of all of the plurality of state items of each of the plurality of batteries 1 to the information terminal 3. In this case, in step S26, the communication part 21 is not required to transmit the operation history of all the plurality of state items of one battery to the information terminal 3. After the selection of one abnormal state item by the user is received in step S33, the display part 34 may display the operation history of all of the plurality of state items of one battery. Then, after the related state item is received in step S35, the display part 34 may display the operation history of the related state item among the plurality of displayed state items in a highlighted manner.

Next, the related state item extraction processing of the server 2 in the embodiment of the present disclosure will be described.

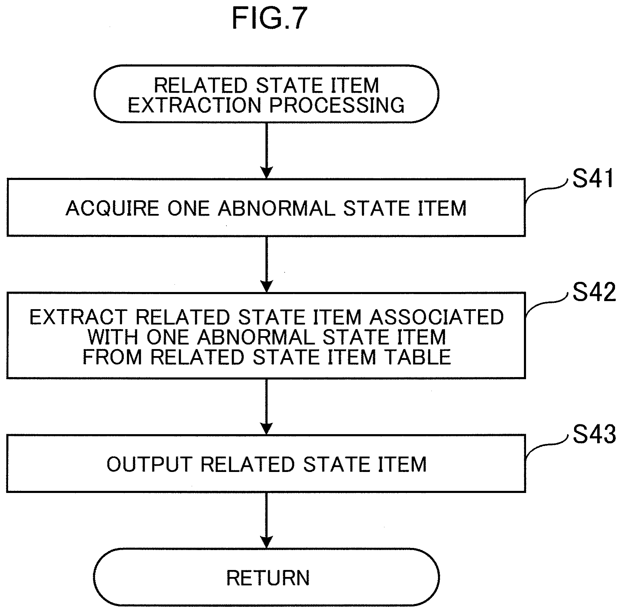

FIG. 7 is a flowchart for describing the related state item extraction processing of the server 2 in the embodiment of the present disclosure.

First, in step S41, the controller 22 acquires one abnormal state item included in the data request received by the communication part 21.

Next, in step S42, the controller 22 extracts the related state item associated with the one abnormal state item from the related state item table.

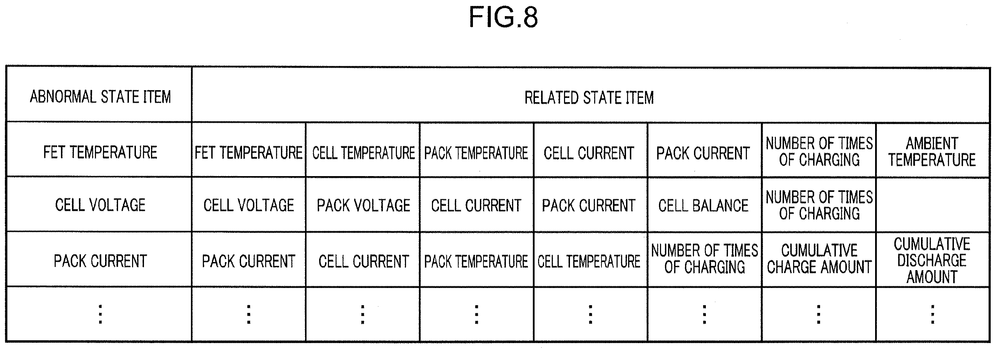

FIG. 8 is a diagram illustrating an example of the related state item table stored in advance in the memory 23 in the present embodiment.

The related state item table is a table in which each of the plurality of abnormal state items is associated with the related state item.

In FIG. 8, the row label item on the vertical axis indicates an abnormal state item, and the column label on the horizontal axis indicates a related state item.

For example, when one abnormal state item is the FET temperature, the controller 22 extracts the FET temperature, the cell temperature, the pack temperature, the cell current, the pack current, the number of times of charging, and the ambient temperature from the related state item table as related state items. Note that the related state items may include one abnormal state item.

Although the controller 22 extracts all of the plurality of related state items corresponding to one abnormal state item, the present disclosure is not limited to this extraction, and the controller 22 may extract some of the plurality of related state items corresponding to one abnormal state item. For example, the controller 22 may extract one of the state items related to temperature (FET temperature, cell temperature, pack temperature, and ambient temperature) and extract one of the state items related to current (cell current and pack current).

Referring to FIG. 7 again, in step S43, the controller 22 outputs the related state item extracted from the related state item table to the communication part 21.

Next, abnormality degree assignment processing and related state item extraction processing of the server 2 in Modification 3 of the present embodiment will be described. The abnormal state item may be associated with an abnormality degree indicating a degree to which the operation history exceeds the threshold. When a plurality of other abnormal state items different from the one abnormal state item exists in the plurality of state items of the one battery, the controller 22 of the server 2 may extract the plurality of other abnormal state items as the plurality of related state items on the basis of the abnormality degree associated with each of the plurality of other abnormal state items. The communication part 31 of the information terminal 3 may acquire the plurality of extracted related state items.

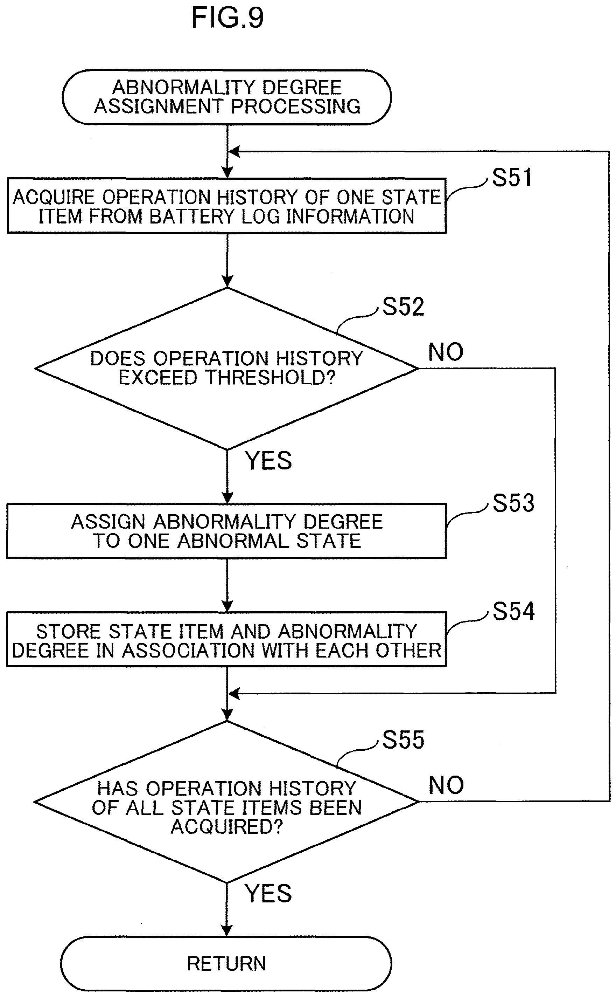

FIG. 9 is a flowchart for describing the abnormality degree assignment processing of the server 2 in Modification 3 of the embodiment of the present disclosure. The abnormality degree assignment processing may be performed between step S22 and step S23 in FIG. 2, or may be performed between step S23 and step S24 in FIG. 2.

First, in step S51, the controller 22 acquires the operation history of one state item from the battery log information stored in the memory 23. At this time, the controller 22 acquires the operation history of one state item for a predetermined period.

Next, in step S52, the controller 22 determines whether the acquired operation history exceeds a threshold value. Here, when it is determined that the operation history does not exceed the threshold (NO in step S52), the processing proceeds to step S55.

On the other hand, when it is determined that the operation history exceeds the threshold (YES in step S52), in step S53, the controller 22 assigns an abnormality degree to one state item.

An assignment method of the abnormality degree may be different for every state item. Here, the assignment method of the abnormality degree will be described.

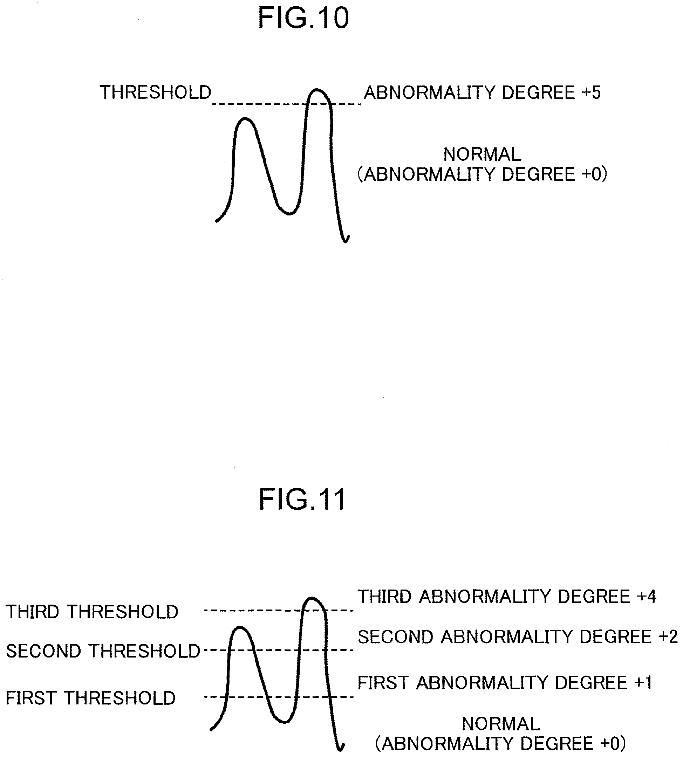

FIG. 10 is a schematic diagram for describing a first assignment method of the abnormality degree in Modification 3 of the present embodiment.

In the first assignment method, it is important whether the operation history of the state item exceeds a threshold. When it is determined that the operation history exceeds the threshold, the controller 22 assigns a predetermined abnormality degree to the state item. As illustrated in FIG. 10, when a peak value of the operation history indicated by a solid line exceeds the threshold indicated by a broken line, the controller 22 assigns a predetermined abnormality degree (for example, +5) to the state item. On the other hand, when the peak value of the operation history does not exceed the threshold, the controller 22 does not assign the predetermined abnormality degree to the state item.

When the peak value of the operation history does not exceed the threshold, the controller 22 may assign an abnormality degree of 0 to the state item. When the abnormality degree of 0 is assigned to the state item in advance, and the peak value of the operation history exceeds the threshold, the controller 22 may assign a predetermined abnormality degree (for example, +5) to the state item. The threshold may be set in advance by the user, or may be set on the basis of an average value or a variance value of the operation history of the state item.

FIG. 11 is a schematic diagram for describing a second assignment method of the abnormality degree in Modification 3 of the present embodiment.

In the second assignment method, it is important how much the operation history of the state item exceeds a threshold. When it is determined that the operation history exceeds the threshold, the controller 22 assigns an abnormality degree corresponding to a degree of exceeding the threshold to the state item. As illustrated in FIG. 11, the controller 22 determines whether the peak value of the operation history indicated by a solid line exceeds the lowest first threshold indicated by a broken line. When the peak value of the operation history exceeds the first threshold, the controller 22 determines whether the peak value of the operation history exceeds a second threshold higher than a first threshold. Here, when the peak value of the operation history does not exceed the second threshold, the controller 22 assigns a first abnormality degree (for example, +1) to the state item. On the other hand, when the peak value of the operation history exceeds the second threshold, the controller 22 determines whether the peak value of the operation history exceeds a third threshold higher than the second threshold. Here, when the peak value of the operation history does not exceed the third threshold, the controller 22 assigns a second abnormality degree (for example, +2) higher than the first abnormality degree to the state item. On the other hand, when the peak value of the operation history exceeds the third threshold, the controller 22 assigns a third abnormality degree (for example, +4) higher than the second abnormality degree to the state item. When the peak value of the operation history does not exceed the first threshold, the controller 22 does not assign the predetermined abnormality degree to the state item.

When the peak value of the operation history does not exceed the first threshold, the controller 22 may assign the abnormality degree of 0 to the state item. The abnormality degree of 0 is assigned to the state item in advance and the peak value of the operation history exceeds the first threshold, the second threshold, or the third threshold, the controller 22 may assign the first abnormality degree, the second abnormality degree, or the third abnormality degree to the state item. The first threshold, the second threshold, and the third threshold may be set in advance by the user, or may be set on the basis of the average value or the variance value of the operation history of the state item.

The controller 22 may assign the abnormality degree in accordance with a period in which the operation history exceeds the threshold. For example, when the value of the operation history exceeds the second threshold continuously for a predetermined period (for example, ten minutes), the controller 22 may assign the second abnormality degree.

The controller 22 may add the abnormality degree in accordance with the number of times the operation history exceeds the threshold. For example, when an abnormality degree of +3 is continuously assigned three times, the controller 22 may further add +1 to the abnormality degree.

Referring to FIG. 9 again, next, in step S54, the controller 22 stores the state item and the abnormality degree in the memory 23 in association with each other.

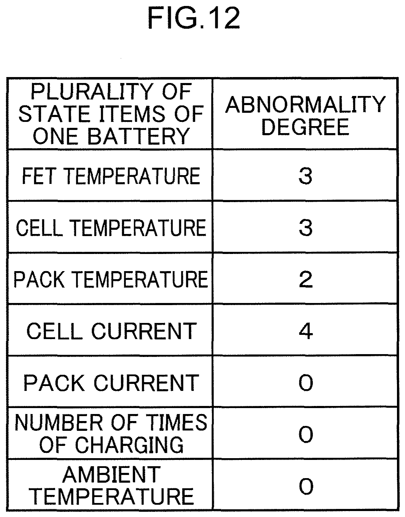

FIG. 12 is a diagram for describing the abnormality degree assigned to a plurality of state items of one battery in Modification 3 of the present embodiment.

As illustrated in FIG. 12, an abnormality degree is assigned to a plurality of state items of one battery. For example, an abnormality degree "3" is assigned to the FET temperature at which the abnormal value is detected, an abnormality degree "3" is assigned to the cell temperature at which the abnormal value is detected, an abnormality degree "2" is assigned to the pack temperature at which the abnormal value is detected, and an abnormality degree "4" is assigned to the cell current at which the abnormal value is detected. For example, the pack current, the number of times of charging, and the ambient temperature at which no abnormal value is detected are assigned the abnormality degree "0".

Referring to FIG. 9 again, next, in step S55, the controller 22 determines whether the operation history of all the state items included in the battery log information has been acquired. Here, when it is determined that the operation history of all the state items has been acquired (YES in step S55), the abnormality degree assignment processing ends. On the other hand, when it is determined that the operation history of all the state items has not been acquired (NO in step S55), the processing returns to step S51, and the controller 22 acquires the operation history of other state items that has not yet been acquired from the battery log information stored in the memory 23.

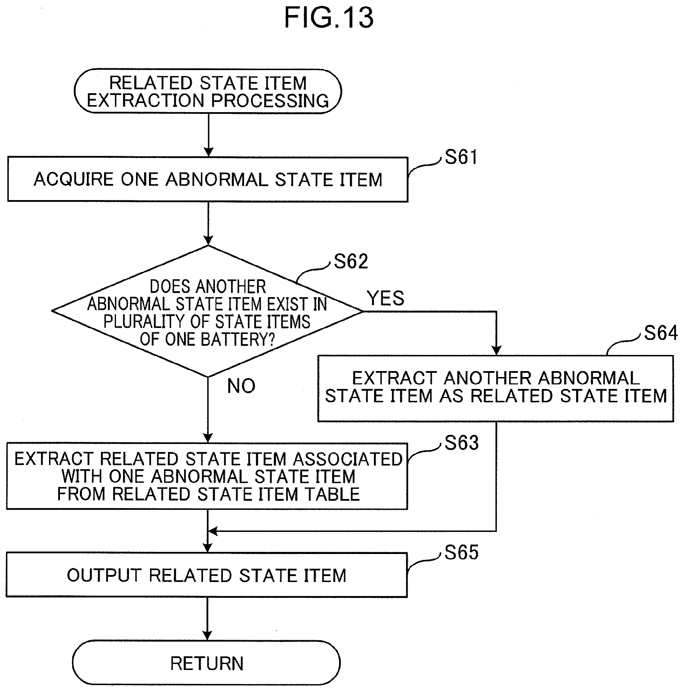

FIG. 13 is a flowchart for describing the related state item extraction processing of the server 2 in Modification 3 of the embodiment of the present disclosure.

Processing in step S61 is the same as the processing in step S41 illustrated in FIG. 7, and will be omitted from description.

Next, in step S62, the controller 22 determines whether another abnormal state item different from one abnormal state item exists in the plurality of state items of the one battery. Here, when it is determined that another abnormal state item different from the one abnormal state item does not exist in the plurality of state items of one battery, that is, when only one abnormal state item exists in the plurality of state items of one battery (NO in step S62), in step S63, the controller 22 extracts the related state item associated with the one abnormal state item from the related state item table. Note that the processing in step S63 is the same as the processing in step S42 illustrated in FIG. 7, and will be omitted from description.

On the other hand, when it is determined that another abnormal state item different from the one abnormal state item exists in the plurality of state items of the one battery (YES in step S62), the controller 22 extracts another abnormal state item as a related state item in step S64.

At this time, the abnormal state item is associated with an abnormality degree indicating a degree to which the operation history exceeds the threshold. When a plurality of other abnormal state items different from the one abnormal state item exists in the plurality of state items of the one battery, the controller 22 may extract the plurality of other abnormal state items as the plurality of related state items on the basis of the abnormality degree associated with each of the plurality of other abnormal state items. For example, the controller 22 may extract another abnormal state item whose abnormality degree is not 0 as a related state item. For example, the controller 22 may extract another abnormal state item whose abnormality degree is equal to or more than a threshold as a related state item.

Next, in step S65, the controller 22 outputs the related state item extracted from the related state item table or the related state item which is another abnormal state item to the communication part 21.

The display part 34 may display the operation history of each of the plurality of related state items in a different mode in accordance with the abnormality degree associated with each of the plurality of other abnormal state items.

When a plurality of other abnormal state items different from the one abnormal state item exists in the plurality of state items of the one battery, the controller 22 may extract the plurality of other abnormal state items as a plurality of related state items, and further extract the related state item associated with the one abnormal state item from the related state item table.

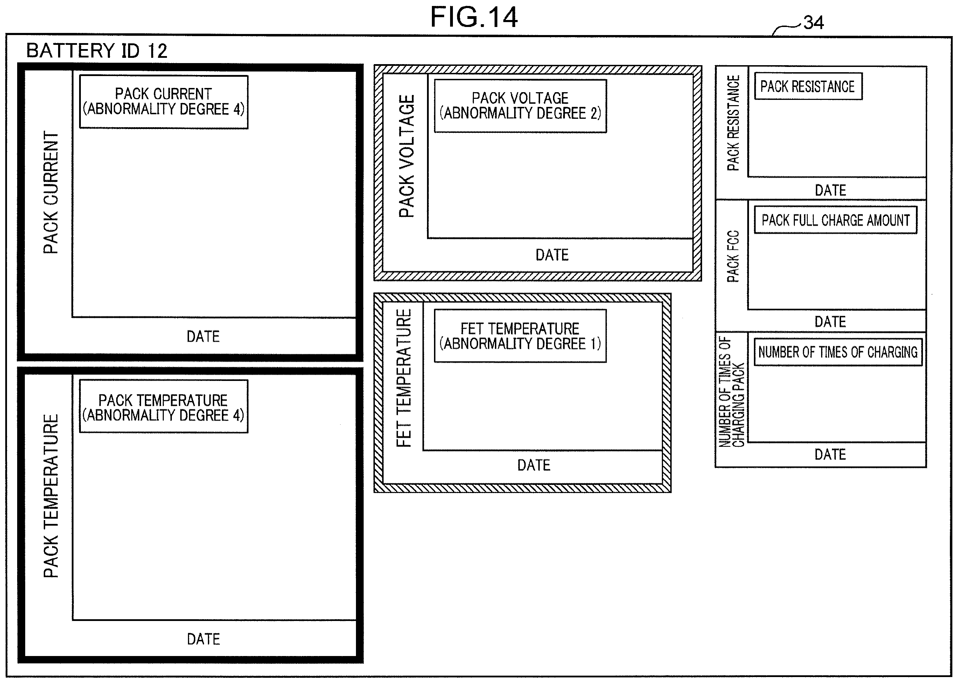

FIG. 14 is a diagram illustrating an example of a related state item display screen displaying the operation history of the related state item in Modification 3 of the embodiment of the present disclosure.

The display part 34 may vary a display mode of the operation history of the related state item on the basis of the level of the abnormality degree of the related state item. For example, the display part 34 may display the operation history of the related state item in descending order of the abnormality degree of the related state item. For example, the display part 34 may vary the color of the frame surrounding the periphery of the operation history of the related state item in accordance with the abnormality degree of the related state item. For example, the display part 34 may vary the thickness of the frame surrounding the periphery of the operation history of the related state item in accordance with the abnormality degree of the related state item. The display part 34 may vary a display size of the operation history of the related state item in accordance with the abnormality degree of the related state item.

In FIG. 14, the pack current, the pack temperature, the pack voltage, and the FET temperature are related state items. The abnormality degree of the pack current is four, the abnormality degree of the pack temperature is four, the abnormality degree of the pack voltage is two, and the abnormality degree of the FET temperature is one. The pack resistance, the pack full charge amount, and the number of times of charging are other state items.

As illustrated in FIG. 14, the periphery of the operation history of the related state item having the highest abnormality degree is surrounded by, for example, a red frame, the periphery of the operation history of the related state item having the second highest abnormality degree is surrounded by, for example, a blue frame, and the periphery of the operation history of the related state item having the third highest abnormality degree is surrounded by, for example, a yellow frame. The operation history of the related state item having the highest abnormality degree is displayed to be larger than the operation history of the related state item having the second highest abnormality degree, and the operation history of the related state item having the second highest abnormality degree is displayed to be larger than the operation history of the related state item having the third highest abnormality degree.

Subsequently, table update processing in the present embodiment will be described.

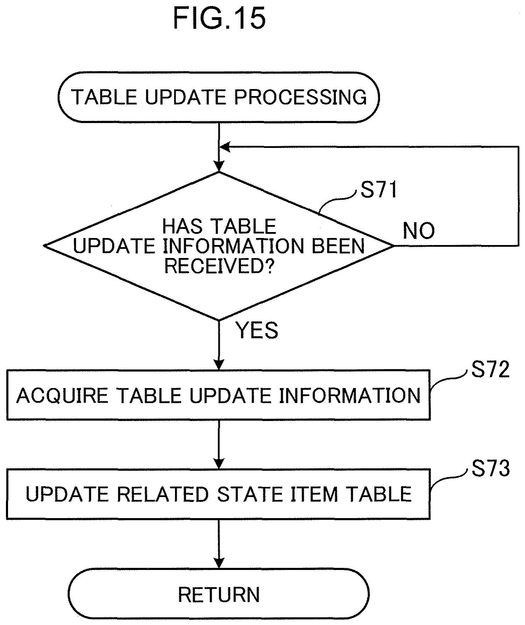

FIG. 15 is a flowchart for describing table update processing of the server 2 in the embodiment of the present disclosure. Note that the table update processing is performed after the processing of step S26 in FIG. 2.

First, in step S71, the controller 22 determines whether table update information for updating the related state item table has been received. The user may confirm the operation history of the related state item displayed on the display part 34 of the information terminal 3 and determine whether the related state item for one abnormal state item is correct. Then, the display part 34 may receive a change by the user of the related state item. The display part 34 receives an input by the user of the state item to be changed and the state item after the change among the displayed related state items. The communication part 31 of the information terminal 3 transmits the table update information including the state item to be changed and the state item after the change to the server 2.

Here, when it is determined that the table update information is not received (NO in step S71), the processing of step S71 is repeated until the table update information is received.

On the other hand, when it is determined that the table update information is received (YES in step S71), in step S72, the controller 22 acquires the table update information received by the communication part 21.

Next, in step S73, the controller 22 updates the related state item table stored in the memory 23 on the basis of the state item to be changed and the state item after change included in the table update information. The controller 22 changes the state item to be changed in the related state item table stored in the memory 23 to the state item after change. Note that the controller 22 may not only rewrite the state item included in the related state item but also delete the state item included in the related state item or add the state item included in the related state item.

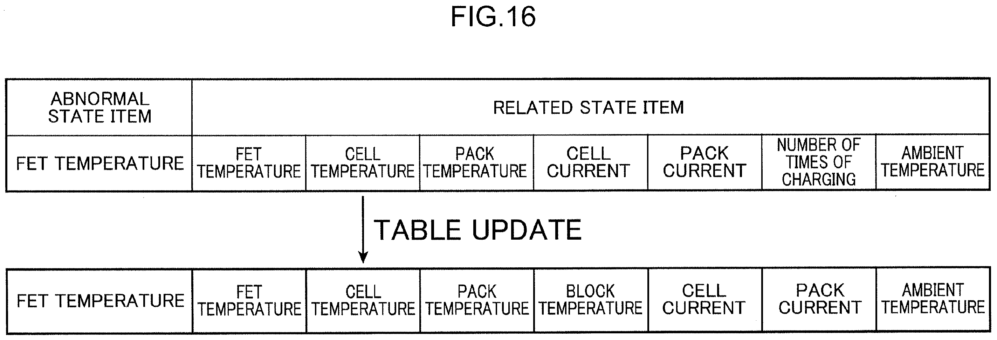

FIG. 16 is a schematic diagram for describing update of the related state item table in the present embodiment.

As illustrated in FIG. 16, in the related state item table before update, related state items such as the FET temperature, the cell temperature, the pack temperature, the cell current, the pack current, the number of times of charging, and the ambient temperature are associated with an abnormal state item such as the FET temperature. On the other hand, in the related state item table after update, related state items such as the FET temperature, the cell temperature, the pack temperature, the cell current, the pack current, a block temperature, and the ambient temperature are associated with the abnormal state item such as the FET temperature. In this case, since the block temperature is more important than the number of times of charging than the FET temperature, the number of times of charging in the related state item table is changed to the block temperature.

In this manner, a user's feedback on the displayed related state item is received and reflected in the related state item table, and thus, the operation history of the related state item related to one abnormal state item can be displayed.

Note that a weight value may be associated with a state item included in the related state item in the related state item table, and the controller 22 may extract the related state item in accordance with a magnitude of the weight value associated with the state item. Then, the controller 22 may change the related state item to be extracted by decreasing the weight value of the state item to be changed in the related state item table and increasing the weight value of the state item after change.

Next, the related state item extraction processing of the server 2 in Modification 4 of the present embodiment will be described. When another abnormal state item different from the one abnormal state item exists in the plurality of state items of one battery, the controller 22 of the server 2 may extract the other abnormal state item as the related state item. Then, the controller 22 may predict an error that has occurred in one battery on the basis of one abnormal state item and a combination of another abnormal state item.

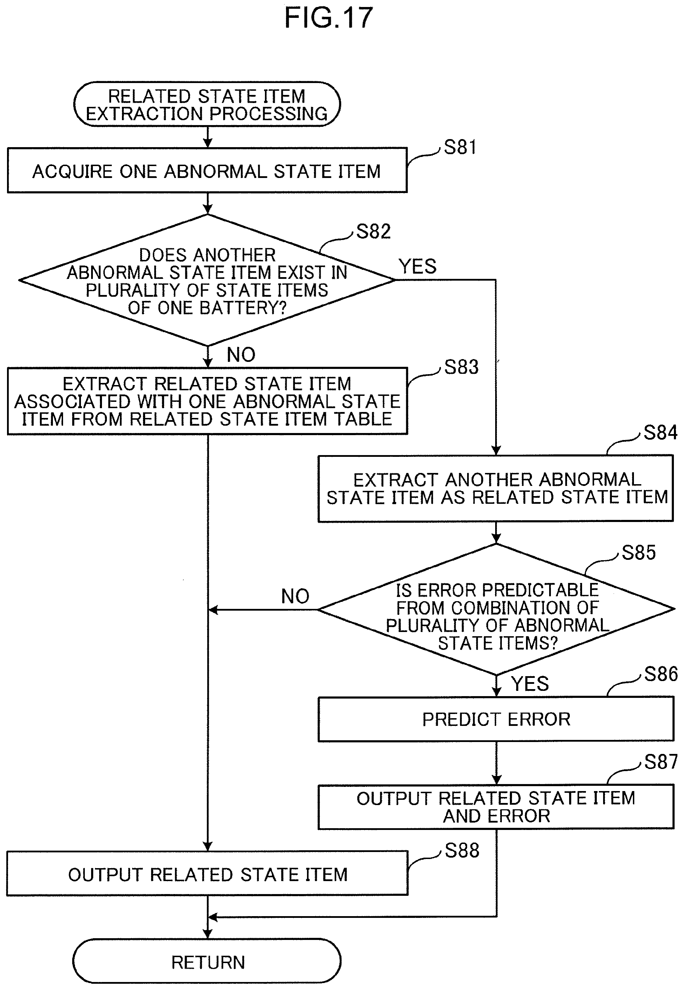

FIG. 17 is a flowchart for describing the related state item extraction processing of the server 2 in Modification 4 of the embodiment of the present disclosure.

The processing of Steps S81 to S84 is the same as the processing of Steps S61 to S64 illustrated in FIG. 13, and will be omitted from description.

Next, in step S85, the controller 22 determines whether error prediction is possible from a combination of one abnormal state item and another abnormal state item. The memory 23 stores in advance a prediction error table in which a combination of a plurality of abnormal state items is associated with an error item indicating an error predicted from the combination of the plurality of abnormal state items. The controller 22 refers to the prediction error table stored in advance in the memory 23, and determines whether an error associated with the combination of one abnormal state item and another abnormal state item exists. At this time, when an error associated with the combination of one abnormal state item and another abnormal state item exists, the controller 22 determines that error prediction is possible. When an error associated with the combination of one abnormal state item and another abnormal state item does not exist, the controller 22 determines that error prediction is impossible.

Here, when it is determined that error prediction is impossible from the combination of one abnormal state item and another abnormal state item (NO in step S85), the processing proceeds to step S88.

On the other hand, when it is determined that error prediction is possible from the combination of one abnormal state item and another abnormal state item (YES in step S85), the controller 22 predicts an error that has occurred in one battery in step S86.

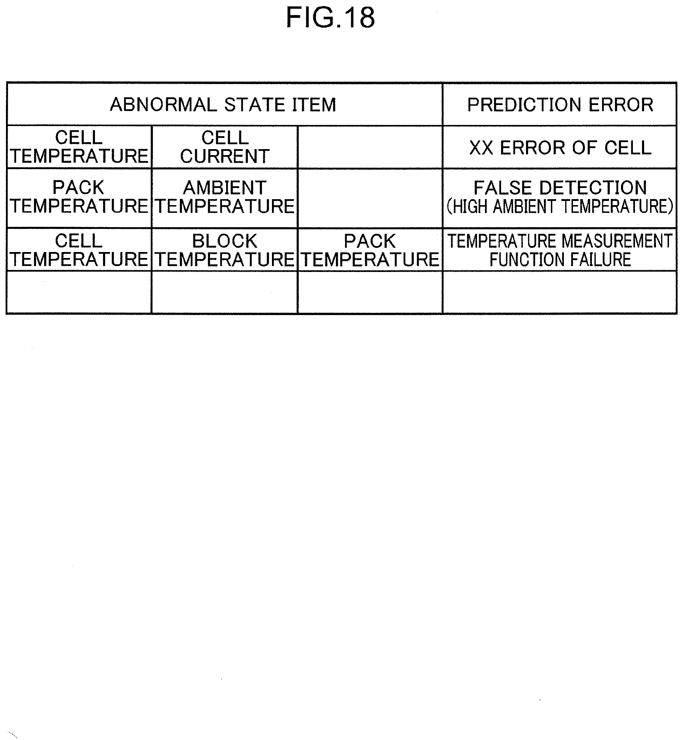

FIG. 18 is a diagram illustrating an example of the prediction error table in Modification 4 of the embodiment of the present disclosure.

As illustrated in FIG. 18, in the prediction error table, a combination of a plurality of abnormal state items is associated with predicted error items. For example, a combination of two abnormal state items of the cell temperature and the cell current is associated with an error item of the battery which is "XX error of cell".

The controller 22 refers to the prediction error table stored in advance in the memory 23, and extracts an error associated with the combination of one abnormal state item and another abnormal state item.

In the present embodiment, the controller 22 extracts an error associated with a combination of one abnormal state item and another abnormal state item from the prediction error table stored in advance in the memory 23 to predict an error that has occurred in one battery, but the present disclosure is not limited to this configuration. The controller 22 may predict an error that has occurred in one battery by inputting one abnormal state item and another abnormal state item to a prediction model that outputs an error prediction result when a plurality of abnormal state items is input. The prediction model is created in advance by machine learning.

Referring to FIG. 17 again, next, in step S87, the controller 22 outputs the extracted related state item and the error item indicating the predicted error to the communication part 21.

Note that the processing in step S88 is the same as the processing in step S43 illustrated in FIG. 7, and will be omitted from description.

The communication part 21 of the server 2 transmits the related state item and the error item output from the controller 22 to the information terminal 3. The communication part 31 of the information terminal 3 receives the related state item and the error item transmitted by the server 2. That is, the communication part 31 acquires the extracted related state item and the error item indicating the predicted error. The display part 34 displays the operation history of the related state item and the predicted error item.

Next, the related state item extraction processing of the server 2 in Modification 5 of the present embodiment will be described. The controller 22 of the server 2 may specify another battery similar to one battery among the plurality of batteries 1, and acquire the operation history of the same state item as the related state item among the plurality of state items of the specified another battery. The display part 34 of the information terminal 3 may display the operation history of the related state item, and display the operation history of the state item of another battery same as the related state item of the one battery.

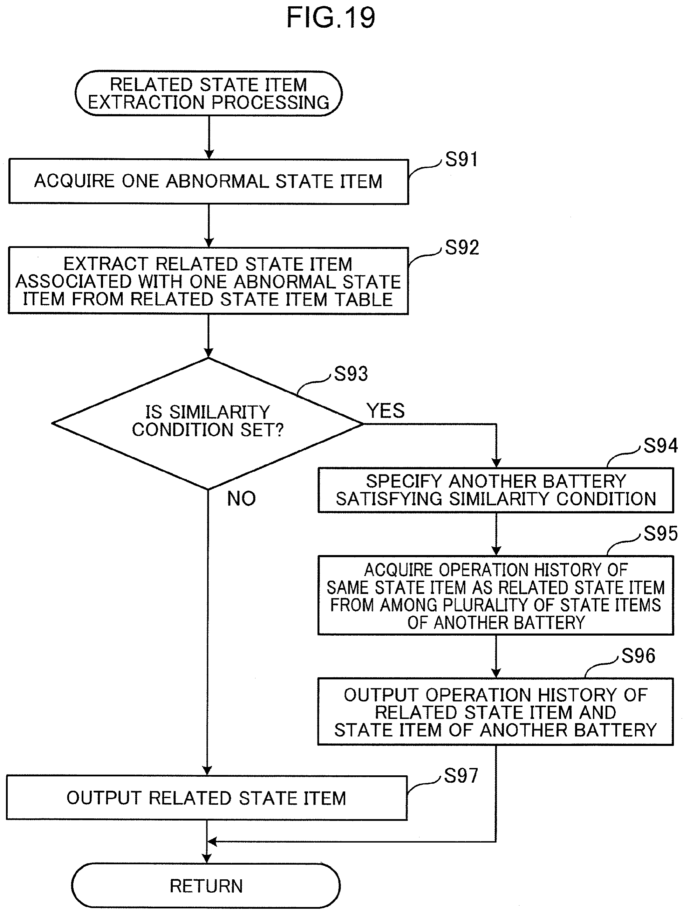

FIG. 19 is a flowchart for describing the related state item extraction processing of the server 2 in Modification 5 of the embodiment of the present disclosure.

Processing in steps S91 and S92 is the same as the processing in steps S41 and S42 illustrated in FIG. 7, and will be omitted from description.

Next, in step S93, the controller 22 of the server 2 determines whether a similarity condition for specifying another battery similar to the one battery has been set. The similarity condition is input by the user. Here, when it is determined that the similarity condition has not been set (NO in step S93), the processing proceeds to step S97.

On the other hand, when it is determined that the similarity condition has been set (YES in step S93), in step S94, the controller 22 specifies another battery that satisfies the similarity condition among the plurality of batteries 1. Here, the similarity condition is that the battery has the same abnormal state item as the abnormal state item of one battery, that the battery is of the same type as the one battery, that the battery is mounted on a device of the same type as a device on which the one battery is mounted, or that the battery is used in an environment similar to the environment of the one battery.

When the similarity condition is that the battery has the same abnormal state item as one battery, the controller 22 specifies a battery having the same abnormal state item as the one battery as another battery. When the similarity condition is being of the same type as one battery, the controller 22 specifies the same type of battery as the one battery as another battery. Note that the battery of the same type as one battery represents, for example, a battery manufactured by the same manufacturer as the one battery or a battery having the same product number as the one battery.

When the similarity condition is that the battery is mounted on the same type of device as the device on which one battery is mounted, the controller 22 specifies a battery mounted on the same type of device as the device on which the one battery is mounted as another battery.

When the similarity condition is that the battery is used in an environment similar to one battery, the controller 22 specifies a battery used in an environment similar to the one battery as another battery. The battery used in an environment similar to one battery refers to, for example, a battery used in the same region as the one battery or a battery used in the same time zone as the one battery.

Note that one similarity condition may be set, or a plurality of similarity conditions may be set. When a plurality of similarity conditions are set, another battery satisfying the plurality of similarity conditions is specified.

When the abnormality degree is assigned to the state item, the similarity condition may be that an abnormal state item having the same abnormality degree as the one battery is included. When the similarity condition is that the battery has an abnormal state item of the same abnormality degree as one battery, the controller 22 may specify a battery having the abnormal state item of the same abnormality degree as the one battery as another battery.

Next, in step S95, the controller 22 acquires an operation history of the same state item as the related state item among the plurality of state items of the specified another battery.

Next, in step S96, the controller 22 outputs the extracted related state item and the acquired operation history of another battery state item to the communication part 21.

Note that the processing in step S97 is the same as the processing in step S43 illustrated in FIG. 7, and will be omitted from description.

The communication part 21 of the server 2 transmits the operation history of the related state item and the state item of another battery output from the controller 22 to the information terminal 3. The communication part 31 of the information terminal 3 receives the operation history of the related state item and the state item of another battery transmitted by the server 2. That is, the communication part 31 acquires the extracted related state item and the operation history of the same state item as the related state item among the plurality of state items of the specified another battery. The display part 34 displays the operation history of the related state item of one battery, and displays the operation history of the state item of another battery same as the related state item of the one battery.

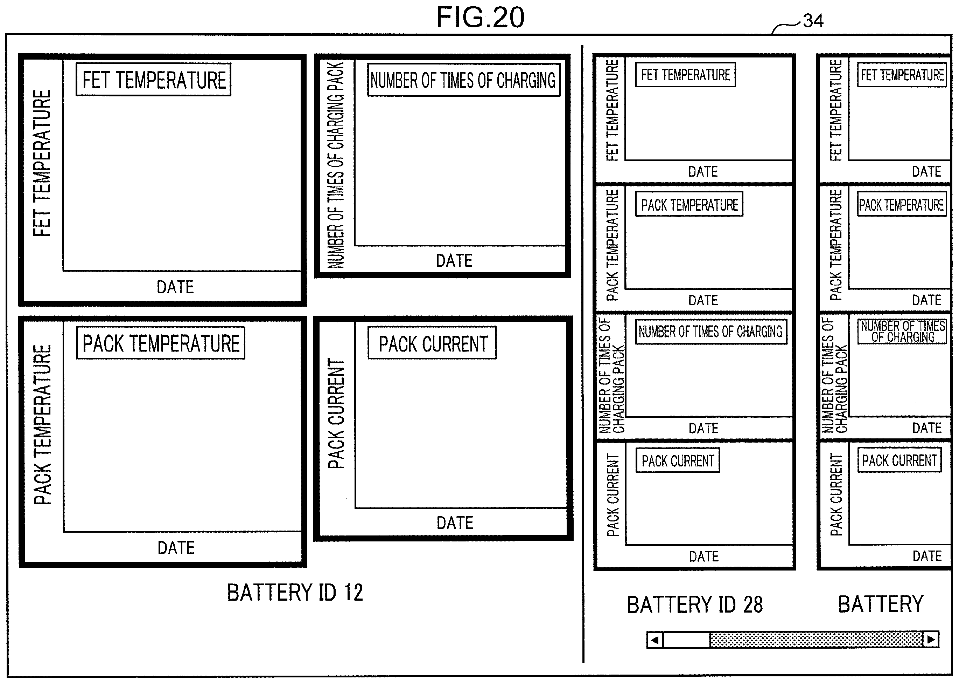

FIG. 20 is a diagram illustrating an example of a related state item display screen displaying an operation history of a related state item in Modification 5 of the present embodiment.

The display part 34 displays the operation history of the related state item of one battery, and displays the operation history of the state item of another battery same as the related state item of the one battery. In FIG. 20, the FET temperature, the pack temperature, the number of times of charging, and the pack current are related state items. As another battery similar to one battery having the battery ID "12", a battery having the battery ID "28" or the like is specified.

In this manner, another battery similar to one battery is specified, the operation history of the related state item of the one battery is displayed, and the operation history of the state item of the other battery same as the related state item of the one battery is displayed. Therefore, since the operation history of the related state item of one battery can be presented to the user in comparison with the operation history of the state item of the other battery same as the related state item of the one battery, it is possible to support the user's determination of what type of error has occurred in the battery. In another similar battery, it is possible to support determination by the user as to whether an error similar to the error in one battery occurs, or prediction by the user as to whether there is a possibility that an error similar to the error in the one battery occurs.

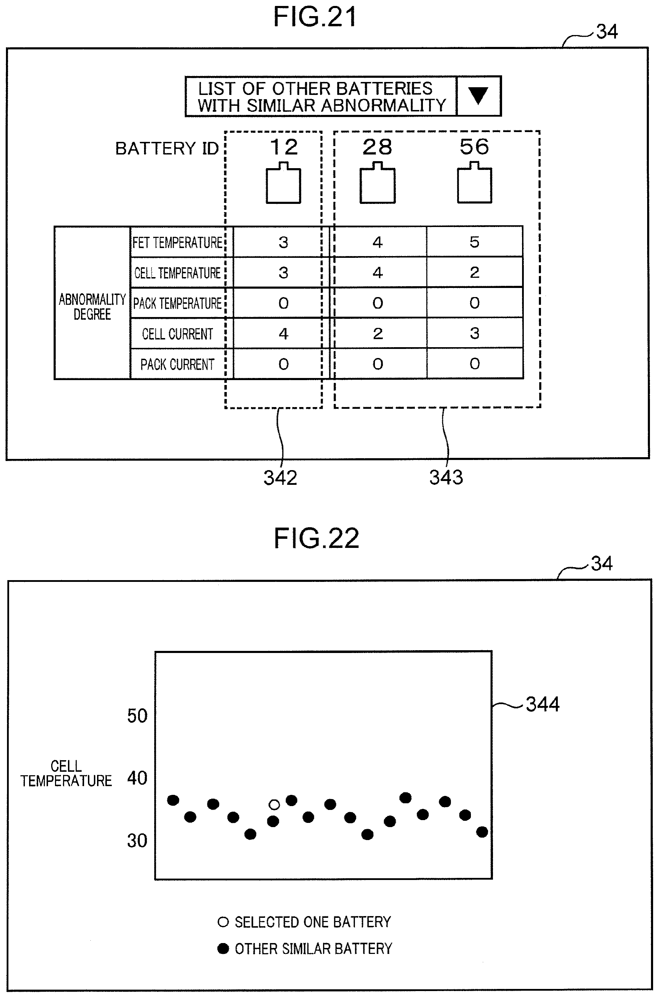

FIG. 21 is a diagram illustrating another example of the related state item display screen displaying the operation history of the related state item in Modification 5 of the present embodiment.

As illustrated in FIG. 21, the display part 34 may display an abnormality degree 342 of the related state item of one battery and an abnormality degree 343 of the related state item of another battery in a table format.

FIG. 22 is a diagram illustrating an example of a display screen displaying a value of the related state item of one battery and a value of the related state item of another battery in Modification 5 of the present embodiment.

The display part 34 may display a mapping image 344 in which the value of the related state item of one battery and the value of the related state item of another battery are mapped on two-dimensional coordinates.

In the mapping image 344 in FIG. 22, the value of the cell temperature is mapped on the two-dimensional coordinates. A white dot indicates the value of the cell temperature of selected one battery, and a black dot indicates the value of the cell temperature of a plurality of other batteries similar to the one battery.

In this manner, by mapping the value of the related state item of one battery and the value of the related state item of another battery on the two-dimensional coordinates, it is possible to compare the value of the related state item of the one battery with the value of the related state item of the other battery, and it is possible to confirm whether the value of the related state item of the one battery is an abnormal value from the comparison result.

In Modification 5 of the present embodiment, when another abnormal state item different from the one abnormal state item exists in the plurality of state items of one battery, the controller 22 may extract the other abnormal state item as the related state item. Then, the controller 22 may predict an error that has occurred in one battery on the basis of one abnormal state item and a combination of another abnormal state item. The controller 22 may specify, as another battery, a battery in which the same error as the predicted error has occurred in the past among the plurality of batteries 1. That is, when an error occurring in one battery is predicted, the similarity condition may be that the same error as the predicted error of one battery has occurred in the past. When the similarity condition is that the same error as the predicted error of one battery has occurred in the past, the controller 22 may specify a battery in which the same error as the predicted error has occurred in the past as another battery.

When the user specifies an error that has occurred in the battery 1, by storing the abnormal state item and the specified error in association with each other, it is possible to specify another battery in which the same error as the predicted error of one battery has occurred in the past.

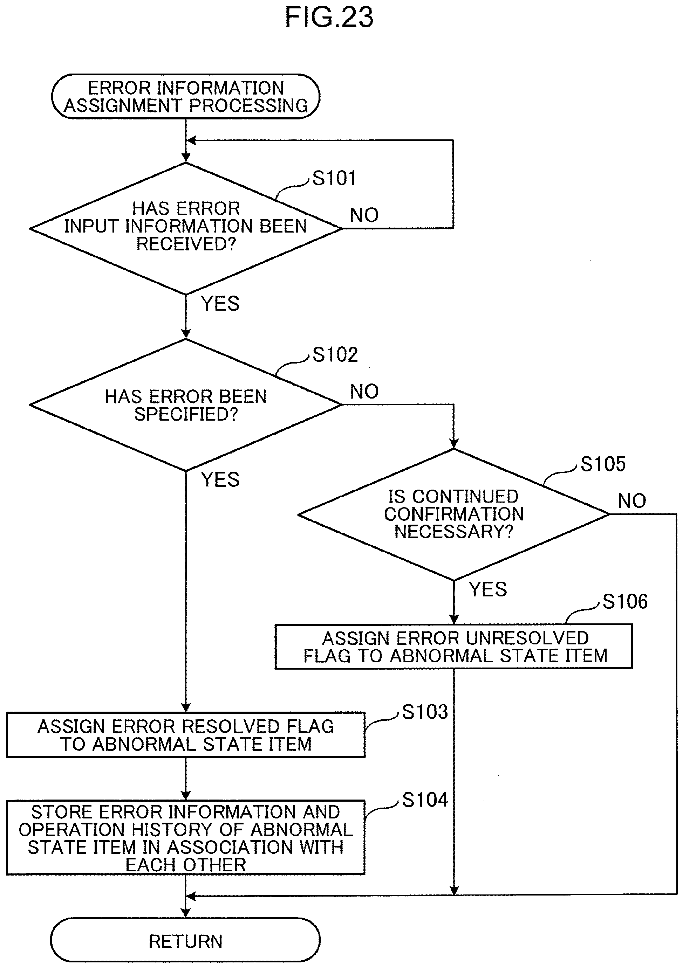

FIG. 23 is a flowchart for describing error information assignment processing of the server 2 in the embodiment of the present disclosure. Note that the error information assignment processing is performed after the processing of step S26 in FIG. 2.

First, in step S101, the controller 22 determines whether error input information for specifying an error occurring in one battery has been received. The user may confirm the operation history of the related state item displayed on the display part 34 of the information terminal 3 and determine what type of error has occurred in one battery. Then, the display part 34 may receive an input of an error occurring in one battery by the user. The communication part 31 of the information terminal 3 transmits the error input information including an error input by the user to the server 2.

The user may not be able to determine what type of error has occurred in one battery, and the error is not necessarily specified by the user. When it is not known what type of error has occurred in one battery, the display part 34 may receive an input by the user of information indicating that an error that has occurred in one battery is not specified. The communication part 31 of the information terminal 3 may transmit, to the server 2, the error input information including information indicating whether an error is not specified and whether continued confirmation is necessary.

Here, when it is determined that the error input information has not been received (NO in step S101), the processing of step S101 is repeated until the error input information is received.

On the other hand, when it is determined that the error input information has been received (YES in step S101), in step S102, the controller 22 determines whether an error has been specified.

Here, when it is determined that an error has been specified (YES in step S102), in step S103, the controller 22 assigns an error resolved flag to the abnormal state item.

Next, in step S104, the controller 22 stores error information indicating what type of error has occurred and the operation history of the abnormal state item in the memory 23 in association with each other. The controller 22 may store the error information and the abnormality degree of the abnormal state item in the memory 23 in association with each other.

On the other hand, when it is determined that an error has not been specified (NO in step S102), in step S105, the controller 22 determines whether continued confirmation of the abnormal state item is necessary. When the information indicating that the continued confirmation is necessary is included in the error input information, the controller 22 determines that the continued confirmation of the abnormal state item is necessary.

Here, when it is determined that the continued confirmation of the abnormal state item is unnecessary (NO in step S105), the processing ends.

On the other hand, when it is determined that the continued confirmation of the abnormal state item is necessary (YES in step S105), in step S106, the controller 22 assigns an error unresolved flag to the abnormal state item. Then, when the plurality of abnormal state items is displayed in a list, the controller 32 of the information terminal 3 may determine which one of the error resolved flag or the error unresolved flag is assigned to each of the plurality of abnormal state items. The controller 32 may display a list of the plurality of abnormal state items so that whether an error is specified is recognizable.

Since the error information and the operation history of the abnormal state item are stored in the memory 23 in association with each other, a battery in which the same error as the predicted error has occurred in the past can be specified as another battery.

Next, the related state item extraction processing of the server 2 in Modification 6 of the present embodiment will be described. The controller 22 of the server 2 may extract the related state item associated with the selected one abnormal state item from the table in which each of the plurality of abnormal state items and the related state item are associated in advance. The controller 22 may calculate a feature amount on the basis of the operation history of the related state item. The controller 22 may execute clustering by using the operation history of the plurality of past state items of each of the plurality of batteries 1 as a data set, and create a mapping image in which a clustering result is mapped on a two-dimensional space and the feature amount is plotted on the two-dimensional space. The communication part 31 of the information terminal 3 may acquire the extracted related state item and the created mapping image. The display part 34 of the information terminal 3 may display the operation history of the related state item and the mapping image.

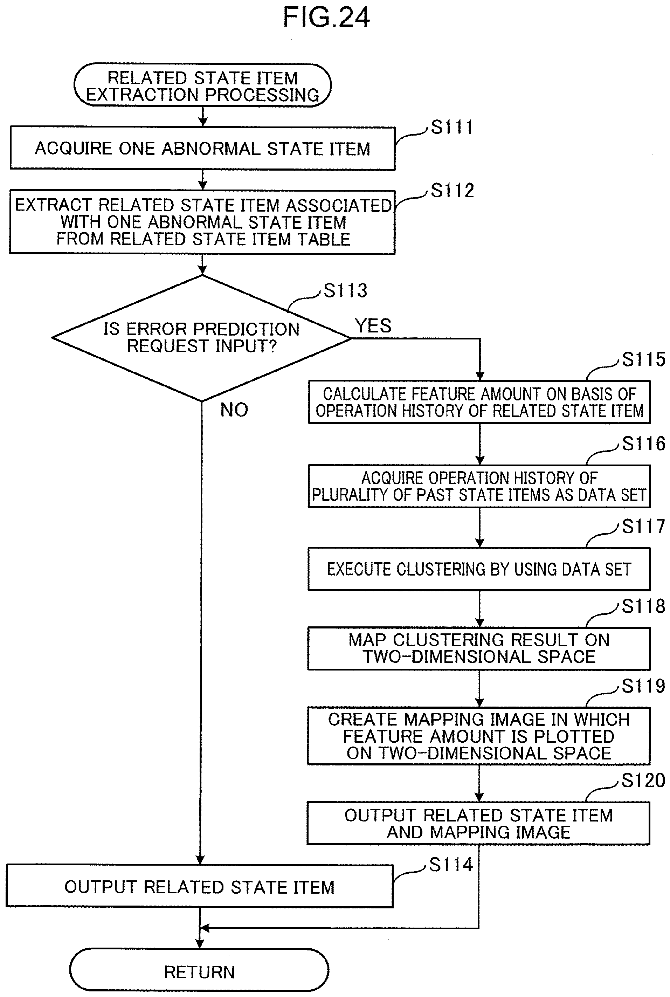

FIG. 24 is a flowchart for describing the related state item extraction processing of the server 2 in Modification 6 of the embodiment of the present disclosure.

Processing in steps S111 and S112 is the same as the processing in steps S41 and S42 illustrated in FIG. 7, and will be omitted from description.

Next, in step S113, the controller 22 of the server 2 determines whether an error prediction request has been input. The error prediction request is input by the user. A user who wishes to predict an error that has occurred in one battery inputs an error prediction request. Here, when it is determined that the error prediction request has not been input (NO in step S113), the processing proceeds to step S114.

Note that the processing in step S114 is the same as the processing in step S43 illustrated in FIG. 7, and will be omitted from description.

On the other hand, when it is determined that an error prediction request has been input (YES in step S113), in step S115, the controller 22 calculates a feature amount on the basis of the extracted operation history of the related state item.

Next, in step S116, the controller 22 acquires the operation history of a plurality of past state items of each of the plurality of batteries 1 as a data set.

Next, in step S117, the controller 22 executes clustering by using the acquired data set. The operation history of the plurality of state items can be classified into a plurality of similar clusters. A technique of automatically performing this classification is clustering. In Modification 6 of the present embodiment, clustering is performed by using a conventional clustering algorithm. As an applicable clustering algorithm, for example, a K-means method is used.

Next, in step S118, the controller 22 maps the clustering result on a two-dimensional space.

Next, in step S119, the controller 22 creates a mapping image in which the calculated feature amount is plotted on a dimensional space.

Next, in step S120, the controller 22 outputs the extracted related state item and the created mapping image to the communication part 21.

The communication part 21 of the server 2 transmits the related state item and the mapping image output from the controller 22 to the information terminal 3. The communication part 31 of the information terminal 3 receives the related state item and the mapping image transmitted by the server 2. That is, the communication part 31 acquires the extracted related state item and the created mapping image. The display part 34 displays the operation history of the related state item of one battery and the mapping image.

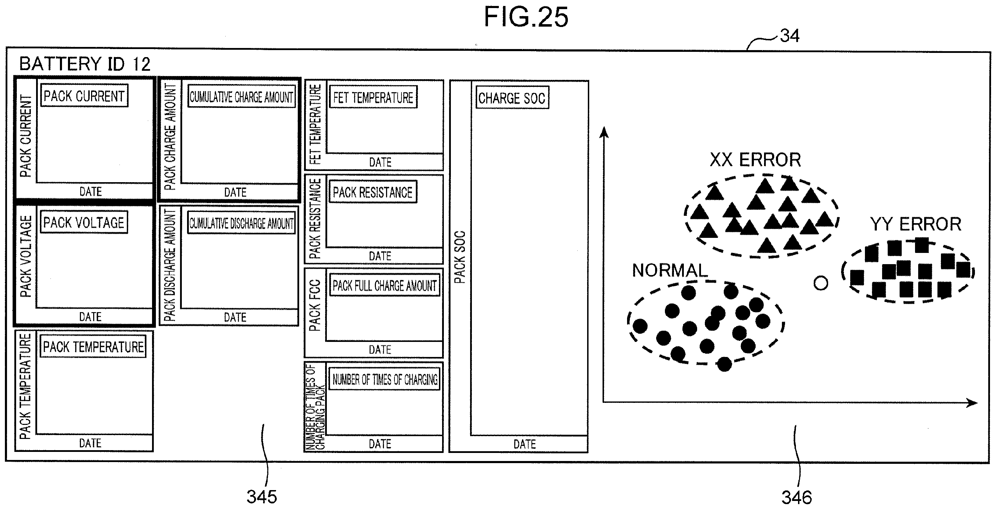

FIG. 25 is a diagram illustrating an example of a related state item display screen displaying an operation history of a related state item in Modification 6 of the present embodiment.

The display part 34 displays an operation history 345 of the related state item of one battery and a mapping image 346. The operation history 345 of the related state item of one battery illustrated in FIG. 25 is the same as the operation history of the related state item of one battery illustrated in FIG. 6. The mapping image 346 is classified into three clusters as a result of performing clustering on the data set, and is classified into a cluster determined to be normal, a cluster determined to be an XX error, and a cluster determined to be a YY error. In the mapping image 346, a white dot indicates the feature amount of the operation history of the related state item. An error generated in one battery can be predicted on the basis of a distance between the feature amount and each cluster. For example, when the dot indicating the feature amount is closest to the cluster determined as the YY error, the error generated in one battery can be predicted to be the YY error.

Note that, in each of the above embodiments, each constituent element may be implemented by including dedicated hardware or by executing a software program suitable for each constituent element. Each constituent element may be implemented by a program execution part, such as a CPU or a processor, reading and executing a software program recorded in a recording medium such as a hard disk or a semiconductor memory. A program may be recorded onto a recording medium and transferred or transferred via a network, so that the program is performed by another independent computer system.

Some or all functions of the device according to the embodiment of the present disclosure are implemented as large scale integration (LSI), which is typically an integrated circuit. These may be individually integrated into one chip, or may be integrated into one chip so as to include some or all of these. Circuit integration is not limited to LSI, and may be implemented by a dedicated circuit or a general-purpose processor. A field programmable gate array (FPGA), which can be programmed after manufacturing of LSI, or a reconfigurable processor in which connection and setting of circuit cells inside LSI can be reconfigured may be used.

Some or all functions of the device according to the embodiments of the present disclosure may be implemented by a processor such as a CPU executing a program.

All numbers used above are illustrated to specifically describe the present disclosure, and the present disclosure is not limited to the illustrated numbers.

The order in which steps illustrated in the above flowchart are executed is for specifically describing the present disclosure, and may be any order other than the above order as long as a similar effect is obtained. Some of the above steps may be executed simultaneously (in parallel) with other steps.

### Industrial Applicability

Since the technique of the present disclosure can support the user's determination of what type of error has occurred in the battery, the technique is useful as a technique of displaying the operation history of the battery in which an abnormal value has been detected.

## Claims

1. An information processing method in a computer, the method comprising:
acquiring a plurality of abnormal state items indicating a state item for which an abnormal value is detected from among a plurality of state items indicating a plurality of states of a plurality of batteries;
upon receiving selection of one abnormal state item of one battery among the plurality of abnormal state items having been acquired, acquiring a related state item indicating a state item related to the one abnormal state item having been selected from among the plurality of state items of the one battery; and
displaying an operation history of the related state item having been acquired.

2. The information processing method according to claim 1, further comprising acquiring the operation history of the plurality of state items of the one battery,
wherein in the displaying of the operation history, the operation history of the plurality of state items having been acquired is displayed, and the operation history of the related state item having been acquired is displayed in a mode different from an operation history of another state item other than the related state item.

3. The information processing method according to claim 1 or 2, wherein in the acquiring of the related state item, the related state item associated with the one abnormal state item having been selected is extracted from a table in which each of the plurality of abnormal state items and the related state item are associated in advance, and the related state item having been extracted is acquired.

4. The information processing method according to claim 3, further comprising updating the table to change the current related state item to a new related state item, when a change of the related state item associated with the abnormal state item is received.

5. The information processing method according to claim 1 or 2, wherein in the acquiring of the related state item, when another abnormal state item different from the one abnormal state item exists in the plurality of state items of the one battery, the other abnormal state item is extracted as the related state item, and the related state item having been extracted is acquired.

6. The information processing method according to claim 5, wherein
the abnormal state item is associated with an abnormality degree indicating a degree to which the operation history exceeds a threshold, and
in the acquiring of the related state items, when a plurality of other abnormal state items different from the one abnormal state item exists in the plurality of state items of the one battery, the plurality of other abnormal state items is extracted as a plurality of related state items on a basis of the abnormality degree associated with each of the plurality of other abnormal state items, and the plurality of related state items having been extracted is acquired.

7. The information processing method according to claim 6, wherein in the displaying of the operation history, the operation history of each of the plurality of related state items is displayed in a different mode in accordance with the abnormality degree associated with each of the plurality of other abnormal state items.

8. The information processing method according to claim 1 or 2, wherein
in the acquiring of the related state item, when another abnormal state item different from the one abnormal state item exists in the plurality of state items of the one battery, the other abnormal state item is extracted as a related state item, an error that has occurred in the one battery is predicted on a basis of a combination of the one abnormal state item and the other abnormal state item, and the related state item having been extracted and an error item indicating the error having been predicted are acquired, and
in the displaying of the operation history, the operation history of the related state item and the error item are displayed.

9. The information processing method according to claim 1 or 2, wherein
in the acquiring of the related state item, another battery similar to the one battery is further specified among the plurality of batteries, and an operation history of a same state item as the related state item is acquired among the plurality of state items of the other battery having been specified, and
in the displaying of the operation history, the operation history of the related state item is displayed, and the operation history of the same state item of the other battery as the related state item of the one battery is displayed.

10. The information processing method according to claim 9, wherein
in the specifying of the other battery, a battery having a same abnormal state item as the one battery, a battery of a same type as the one battery, a battery mounted on a device of a same type as a device on which the one battery is mounted, or a battery used in an environment similar to the one battery is specified as the other battery.

11. The information processing method according to claim 9, wherein
in the acquiring of the related state item, when another abnormal state item different from the one abnormal state item exists in the plurality of state items of the one battery, the other abnormal state item is extracted as a related state item, an error that has occurred in the one battery is predicted on a basis of a combination of the one abnormal state item and the other abnormal state item, and a battery in which a same error as the error having been predicted has occurred in past among the plurality of batteries is specified as the other battery.

12. The information processing method according to claim 1 or 2, wherein
in the acquiring of the related state item, the related state item associated with the one abnormal state item having been selected is extracted from a table in which each of the plurality of abnormal state items and the related state item are associated in advance, a feature amount is calculated on a basis of the operation history of the related state item, clustering is executed by using the operation history of the plurality of state items in past of each of the plurality of batteries as a data set, a clustering result is mapped in a two-dimensional space and a mapping image in which the feature amount is plotted in the two-dimensional space is created, and the related state item having been extracted and the mapping image having been created are acquired, and
in the displaying of the operation history, the operation history of the related state item and the mapping image are displayed.

13. An information processing device comprising:
a first acquisition part that acquires a plurality of abnormal state items indicating a state item for which an abnormal value is detected from among a plurality of state items indicating a plurality of states of a plurality of batteries;
a second acquisition part that acquires a related state item, upon receiving selection of one abnormal state item of one battery among the plurality of abnormal state items having been acquired, the related state item indicating a state item related to the one abnormal state item having been selected from among the plurality of state items of the one battery; and
a display part that displays an operation history of the related state item having been acquired.

14. An information processing program that causes a computer to function to:
acquire a plurality of abnormal state items indicating a state item for which an abnormal value is detected from among a plurality of state items indicating a plurality of states of a plurality of batteries;
upon receiving selection of one abnormal state item of one battery among the plurality of abnormal state items having been acquired, acquire a related state item indicating a state item related to the one abnormal state item having been selected from among the plurality of state items of the one battery; and
display an operation history of the related state item having been acquired.
